# EUROPEAN PATENT APPLICATION

(11) **EP 2 083 609 A2**
(43) Date of publication of application: **29.07.2009**
(21) Application number: 09000801.2
(22) Date of filing: 21.01.2009
(51) Int. Cl.: H05K 1/02, H01P 5/08, H04B 10/12

(54) **Optical communication device and method of manufacturing the same**

(30) Priority: 22.01.2008 JP 2008011812
(71) Applicant: Sony Corporation, Tokyo 108-0075 (JP)
(72) Inventor: Kishima, Koichiro, Tokyo 108-0075 (JP)
(74) Representative: Müller - Hoffmann & Partner

(57) **Abstract**

An optical communication device contains a semiconductor chip that performs wireless communication and a wireless-signal-and-optical-signal conversion chip substrate that mounts the semiconductor chip. The semiconductor chip (10) includes a first wireless communication circuit element and a first antenna element (12,13). The first wireless communication circuit element is connected to the first antenna element. The wireless-signal-and-optical-signal conversion chip substrate (20) includes a second wireless communication circuit element, a second antenna element (27,22) and an optical communication element. The second wireless communication circuit element is connected to the second antenna element. The optical communication element is connected to the second wireless communication circuit element. The wireless-signal-and-optical-signal conversion chip substrate mounts the semiconductor chip with the first antenna element of the semiconductor chip and the second antenna element of the wireless-signal-and-optical-signal conversion chip substrate being faced with each other.

## Description

### CROSS REFERENCES TO RELATED APPLICATIONS

The present invention contains subject matter related to Japanese Patent Application JP 2008-011812 filed in the Japanese Patent Office on January 22, 2008, the entire contents of which being incorporated herein by reference.

### BACKGROUND OF THE INVENTION

### Field of the invention:

The present invention relates to an optical communication device and a method of manufacturing the same, which are applicable to a high-speed optical interface apparatus that performs transmission and/or reception of a signal at a high speed between a semiconductor chip and a wireless-signal-and-optical-signal conversion chip.

### Description of Related Art:

In resent years, a user (an operator) has often utilized a high-resolution image through a next generation large capacity optical disc such as Blu-ray Disc (trademark), high-definition broadcasting or the like. In this case, a high-speed Rambus solution having semiconductor-chip-to-semiconductor-chip interconnections by copper (CU) wiring patterns has been employed. In such interconnections, a length of each of the wiring patterns, an arranged angle thereof, positions of the semiconductor chips and the like are stipulated clearly in detail against a reflected wave and/or a stationary wave, which prevents a reflection or the like from occurring. For example, in a high-speed information-processing apparatus, an RAM memory chip is arranged at an angle of 45 degrees obliquely from a semiconductor chip constituting CPU and this semiconductor-chip-to-memory-chip interconnection is realized by a copper (CU) wiring pattern which is bent at right angle on a plane of a board.

In connection with such a high-speed Rambus solution having semiconductor-chip-to-semiconductor-chip interconnections, Japanese Patent Application Publication No. 2006-191077 has disclosed on page 4 and FIG. 1 thereof a waveguide-to-printed-wiring-board (PWB) interconnection. In this waveguide-to-printed-wiring-board (PWB) interconnection, a first RF printed wiring board having a wireless communication function and a second RF printed wiring board having a wireless communication function interconnect through a waveguide. Transmission and reception antennas for the first RF printed wiring board are arranged in a space region provided at an end of the waveguide and transmission and reception antennas for the second RF printed wiring board are arranged in a space region provided at the other end of the waveguide. This enables a wireless communication processing to be realized between the first and second RF printed wiring boards.

Further, there has been disclosed semiconductor-(optical) chip-to-semiconductor-(optical) chip interconnections by an optical fiber in an article, "Chip-to-chip optical interconnects" in Optical Fiber Communication Conference, 2006 and the 2006 National Fiber Optic Engineerings Conference, OFC 2 Volume, Issue, 5-10 March 2006.

In these interconnections, a terabus solution having optochip-to-optochip interconnects by an optical waveguide array has been employed. In such a terabus solution, a transmitter-optochip and a receiver-optochip are arranged on an optocard substrate. The transmitter-optochip includes a laser driver integrated circuit (IC) and a VCSEL array. The VCSEL array is arranged just under the laser driver IC. The VCSEL array contains a plurality of light-emitting units that convert an electric signal to an optical signal. The optical waveguide is arranged just under the VCSEL array and a pair of first and second mirrors is arranged at predetermined positions of this optical waveguide.

The receiver-optochip includes a PD array and a receiver IC. The PD array contains a plurality of light-receiving units that convert an optical signal to an electric signal. The PD array is arranged just above the second mirror positioned at one side of the optical waveguide and the receiver IC is arranged just above the PD array. A light-emitting port of the VCSEL array couples the other side of the optical waveguide via the first mirror. The one side of the optical waveguide couples the PD array via the second mirror.

### SUMMARY OF THE INVENTION

According to the above-mentioned Rambus solution having semiconductor-chip-to-semiconductor-chip interconnections, it is difficult to change the length of each of the wiring patterns, the arranged angle thereof, the relative positions of the semiconductor chips and the like. This causes a size of the printed wiring board to be fixed, resulting in limiting freedom in a design of a product mounting the printed wiring board. In this connection, the waveguide-to-printed wiring board (PWB) interconnection disclosed in Japanese Patent Application Publication No. 2006-191077 has the waveguide having a large section, resulting in preventing a product mounting the same from being downsized.

Further, according to the above-mentioned "chip-to-chip optical interconnects", the optochip and the optochip interconnect by an optical waveguide array so that an optical signal can be directly transmitted to each other. An optical waveguide array, however, may be necessary to connect a high-value added semiconductor chip such as CPU. This increases a number of steps in connection with a step of connecting the optical waveguide array to the CPU.

It is desirable to provide an optical communication device and a method of manufacturing the same, which convert an electric signal to an optical signal between a semiconductor chip and an wireless optical chip at a high speed or convert an optical signal to an electric signal between the semiconductor chip and the wireless optical chip at a high speed, so that the semiconductor-chip-to-wireless-optical-chip interconnections can be improved to transmit a signal therebetween at a high speed.

According to an embodiment of the present invention, there is provided an optical communication device containing a semiconductor chip that performs wireless communication and a wireless-signal-and-optical-signal conversion chip substrate that mounts the semiconductor chip. The semiconductor chip includes a first wireless communication circuit element and a first antenna element. The first wireless communication circuit element is connected to the first antenna element. The wireless-signal-and-optical-signal conversion chip substrate includes a second wireless communication circuit element, a second antenna element and an optical communication element. The second wireless communication circuit element is connected to the second antenna element. The optical communication element is connected to the second wireless communication circuit element. The wireless-signal-and-optical-signal conversion chip substrate mounts the semiconductor chip with the first antenna element of the semiconductor chip and the second antenna element of the wireless-signal-and-optical-signal conversion chip substrate being faced with each other.

In the embodiment of the optical communication device relating to the present invention, under the semiconductor chip, the optical communication element, for example, the electric-signal-to-optical-signal conversion element, of the wireless-signal-and-optical-signal conversion chip substrate receives any rapid wireless signal sent from the first wireless communication circuit element of the semiconductor chip through the first and second antenna elements faced to each other and the second wireless communication circuit element and converts it to an optical signal to emit the optical signal thus converted to outside through the optical fiber. Alternatively, under the semiconductor chip, the optical communication element, for example, the optical-signal-to-electric-signal conversion element, of the wireless-signal-and-optical-signal conversion chip substrate receives light from outside through the optical fiber and converts it to an electric signal. The second wireless communication circuit element of the wireless-signal-and-optical-signal conversion chip substrate then sends the electric signal thus converted within wireless communication to the first wireless communication circuit element of the semiconductor chip through the first and second antenna elements, which are faced to each other.

Consequently, the wireless-signal-and-optical-signal conversion chip substrate including the optical fiber may connect an already existing semiconductor chip having an antenna element built-in under the semiconductor chip without any difficulty. This enables to be presented an optical communication device with a high-speed optical interface, which is possible to send or receive at a high speed the signal converted from electric signal to the optical signal and vice versa between the semiconductor chip and the wireless-signal-and-optical-signal conversion chip substrate.

According to another embodiment of the present invention, there is provided a method of manufacturing an optical communication device that performs an optical communication by connecting to an optical fiber a semiconductor chip including a first wireless communication circuit element and a first antenna element. The first wireless communication circuit element is connected to the first antenna element. The method includes the steps of preparing a wireless-signal-and-optical-signal conversion chip substrate by setting a second wireless communication circuit element that performs wireless communication on the semiconductor chip, a second antenna element that performs the wireless communication on the semiconductor chip and an optical communication element that performs an optical communication between the second wireless communication circuit element and the optical fiber on a substrate body and by connecting the second wireless communication circuit element, the second antenna element, the optical communication element, and the optical fiber to each other, and aligning the first antenna element of the semiconductor chip and the second antenna element of the wireless-signal-and-optical-signal conversion chip substrate to be faced with each other and mounting the semiconductor chip on the wireless-signal-and-optical-signal conversion chip substrate.

In the embodiment of the method of manufacturing the optical communication device relating to the present invention, the wireless-signal-and-optical-signal conversion chip substrate is prepared, for example, by setting the second antenna element, the second wireless communication circuit element, the electric-signal-to-optical-signal conversion element, the optical-signal-to-electric-signal conversion element and the optical fiber on a substrate body and by connecting the second antenna element to the second wireless communication circuit element, which are arranged on the substrate body, connecting the electric-signal-to-optical-signal conversion element and the optical-signal-to-electric-signal conversion element to the second wireless communication circuit element, and connecting the electric-signal-to-optical-signal conversion element and the optical-signal-to-electric-signal conversion element to the optical fiber. The first antenna element of the semiconductor chip and the second antenna element of the wireless-signal-and-optical-signal conversion chip substrate are then aligned so to be faced with each other and the wireless-signal-and-optical-signal conversion chip substrate mounts the semiconductor chip. This enables the semiconductor-chip-to-optical-fiber interconnection to be realized according to a wireless-to-optical connection at only one connection step. Accordingly, it is possible to manufacture an optical communication device with a high-speed optical interface, which is possible to send or receive at a high speed the signal converted from electric signal to the optical signal and vice versa between the semiconductor chip and the wireless-signal-and-optical-signal conversion chip substrate.

The concluding portion of this specification particularly points out and directly claims the subject matter of the present invention. However, those skilled in the art will best understand both the organization and method of operation of the invention, together with further advantages and objects thereof, by reading the remaining portions of the specification in view of the accompanying drawing(s) wherein like reference characters refer to like elements.

### BRIEF DESCRIPTION OF THE DRAWINGS

FIG. 1 is a perspective view of an optical communication device 100 as a first embodiment of the invention for showing a configuration (No. 1) thereof;
FIG. 2 is a sectional view of the optical communication device 100 for showing the configuration (No. 2) thereof;
FIG. 3A is a schematic plan view of the optical communication device 100 for showing a manufacturing example (No. 1) thereof and FIG. 3B is a partly schematic sectional view of the optical communication device 100 taken along the lines X1-X1 shown in FIG. 3A;
FIG. 4A is a schematic plan view of the optical communication device 100 for showing the manufacturing example (No. 2) thereof and FIG. 4B is a partly schematic sectional view of the optical communication device 100 taken along the lines X1-X1 shown in FIG. 4A;
FIG. 5A is a schematic plan view of the optical communication device 100 for showing the manufacturing example (No. 3) thereof and FIG. 5B is a partly schematic sectional view of the optical communication device 100 taken along the lines X1-X1 shown in FIG. 5A;
FIG. 6A is a schematic plan view of the optical communication device 100 for showing the manufacturing example (No. 4) thereof and FIG. 6B is a partly schematic sectional view of the optical communication device 100 taken along the lines X1-X1 shown in FIG. 6A;
FIG. 7A is a schematic plan view of the optical communication device 100 for showing the manufacturing example (No. 5) thereof and FIG. 7B is a partly schematic sectional view of the optical communication device 100 taken along the lines X1-X1 shown in FIG. 7A;
FIG. 8 is a partly schematic sectional view of the optical communication device 100 for showing the manufacturing example (No. 6) thereof;
FIG. 9 is a block diagram showing an operation example of the optical communication device 100 when a wireless-signal-and-optical-signal conversion chip substrate is connected to a semiconductor chip within wireless communication;
FIG. 10 is a schematic plan view of an optical communication device 200 as a second embodiment of the invention for showing a configuration thereof;
FIGS. 11A through 11C are sectional views of the optical communication device 200 for showing a manufacturing example thereof;
FIG. 12 is a schematic plan view of an optical communication device 300 as a third embodiment of the invention for showing a configuration thereof;
FIG. 13 is a sectional view of an optical communication device 400 as a fourth embodiment of the invention for showing a configuration thereof;
FIGS. 14A and 14B are sectional views of the optical communication device 400 for showing a manufacturing example (No. 1) thereof;
FIG. 15 is a sectional view of the optical communication device 400 for showing a manufacturing example (No. 2) thereof;
FIG. 16 is a schematic plan view of an optical communication device 500 as a fifth embodiment of the invention for showing a configuration thereof;
FIG. 17 is a sectional view of an optical communication device 600 as a sixth embodiment of the invention for showing a configuration thereof;
FIGS. 18A through 18C are sectional views of the optical communication device 600 for showing a manufacturing example (No. 1) thereof;
FIG. 19 is a sectional view of the optical communication device 600 for showing a manufacturing example (No. 2) thereof;
FIG. 20 is a perspective view of an optical communication device 700 as a seventh embodiment of the invention for showing a configuration thereof;
FIG. 21 is a perspective view of an optical communication device 700A as an variation of the optical communication device 700 for showing a configuration thereof; and
FIG. 22 is a sectional view of an optical communication device 800 as an eighth embodiment of the invention for showing a configuration thereof.

### DESCRIPTION OF THE PREFERRED EMBODIMENTS

The following will describe embodiments of an optical communication device and a manufacturing method of the same relating to the invention with reference to drawings.

### [Embodiment 1]

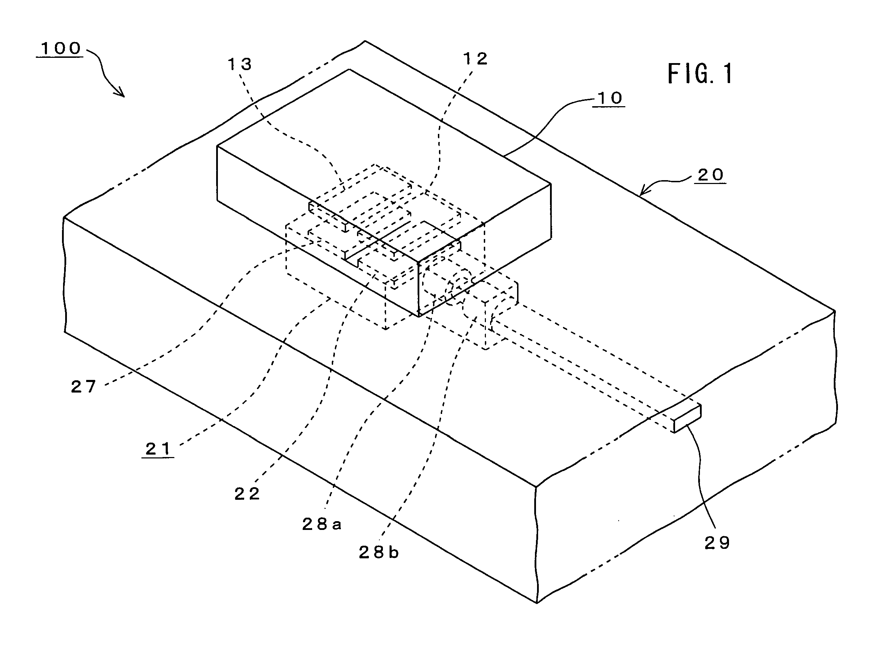

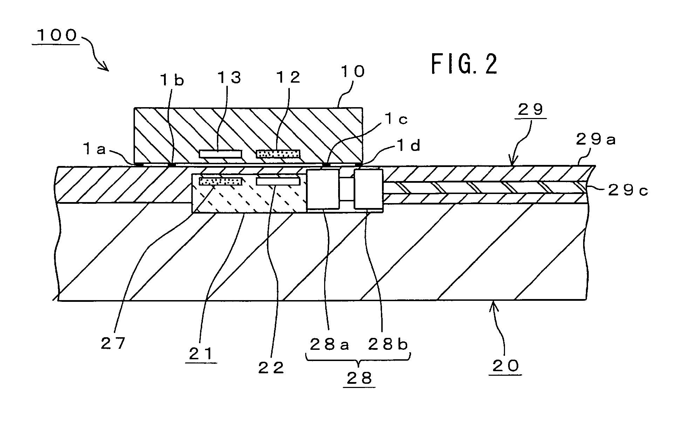

FIG. 1 shows a configuration (No. 1) of the optical communication device 100 and FIG. 2 shows the configuration (No. 2) thereof. The optical communication device 100 shown in FIG. 1 is applicable to a high-speed optical interface apparatus which is possible to send or receive at a high speed a signal converted from electric signal to the optical signal and vice versa between the semiconductor chip and the wireless-signal-and-optical-signal conversion chip substrate.

The optical communication device 100 includes a semiconductor chip 10 with a wireless communication function and a wireless-signal-and-optical-signal conversion chip substrate 20. The wireless-signal-and-optical-signal conversion chip substrate 20 mounts the semiconductor chip 10 which inputs or outputs an image signal and/or an audio signal based on a clock signal having a fast operating frequency. The semiconductor chip 10 includes a central processing unit (CPU) that performs processing on data based on a clock signal having an operating frequency of several GHz or a memory system.

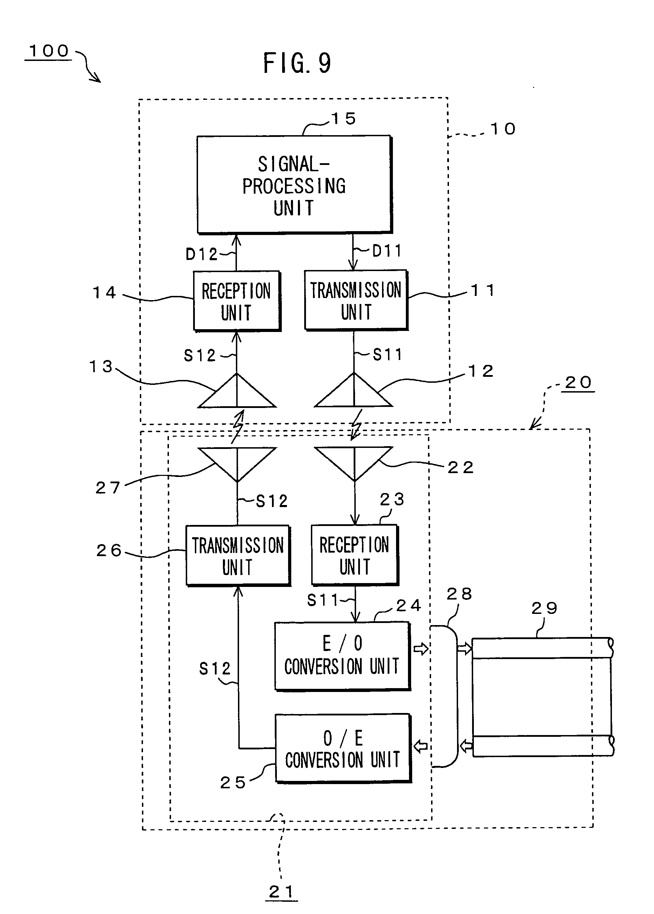

The semiconductor chip 10 also includes a transmission antenna 12 (hereinafter, referred to as only "antenna 12") and a reception antenna 13(hereinafter, referred to as only "antenna 13"). The antennas 12 and 13 are respectively connected to wireless communication circuit elements, which are not shown in FIG. 1, of the semiconductor chip 10 (see FIG.9).

Radio-frequency-to-optical-signal conversion chip 21 (hereinafter, referred to as only "RF-OPT chip 21") constituting the wireless-signal-and-optical-signal conversion chip is embedded into the wireless-signal-and-optical-signal conversion chip substrate 20. The RF-OPT chip 21 has an input/output function of a radio frequency (RF) signal and an RF-signal-to-optical-signal conversion function or an optical-signal-to-RF-signal conversion function. The wireless-signal-and-optical-signal conversion chip substrate 20 also has an RF-signal-to-optical-signal conversion function or an optical-signal-to-RF-signal conversion function. The RF signal is referred to as "an electric signal which is received from the semiconductor chip 10 in wireless communication". The RF-OPT chip 21 converts the RF signal to an optical signal to emit collimated light or converts incident collimated light to an RF signal to transmit the converted one to the semiconductor chip 10 in the wireless communication. The RF-OPT chip 21 has a reception antenna 22 (hereinafter, referred to as only "antenna 22") and a transmission antenna 27 (hereinafter, referred to as only "antenna 27"). These antennas 22, 27 are respectively connected to the wireless communication circuit elements, which are not shown in FIG. 1, of the RF-OPT chip 21 (see FIG.9).

The semiconductor chip 10 is connected to the RF-OPT chip 21, which is set just under the semiconductor chip 10 as shown in FIG. 2, in the wireless communication via the antennas 12, 22, 13, and 27. The wireless-signal-and-optical-signal conversion chip substrate 20 includes the RF-OPT chip 21. In this embodiment, the wireless-signal-and-optical-signal conversion chip substrate 20 mounts the semiconductor chip 10 so that the antenna 12 of the semiconductor chip 10 can be faced with the antenna 22 of the RF-OPT chip 21 and the antenna 13 of the semiconductor chip 10 can be faced with the antenna 27 of the RF-OPT chip 21.

For example, the semiconductor chip 10 has bump electrodes 1a, 1b, 1c, 1d, and so on, which are shown in FIG. 2 as dashed marks in black. The semiconductor chip 10 is mounted on the wireless-signal-and-optical-signal conversion chip substrate 20 by means of flip chip solder-boding. The wireless-signal-and-optical-signal conversion chip substrate 20 contains a thick printed wiring board to some degree, the RF-OPT chip 21 and the optical waveguide 29c. The RF-OPT chip 21 and the optical waveguide 29c are embedded in the wireless-signal-and-optical-signal conversion chip substrate 20. The wireless-signal-and-optical-signal conversion chip substrate 20 has on its top surface a wiring pattern which connects the semiconductor chip 10.

Lenses 28 connects the RF-OPT chip 21 which shapes beam light emitted from the RF-OPT chip 21 so as to form the collimated light. As the lenses 28, two SELFOC lenses 28a, 28b are used. The SELFOC lens 28a connects the RF-OPT chip 21 and the SELFOC lens 28b connects the optical waveguide 29c.

An optical fiber 29 which is constituted of the optical waveguide 29c and low refractive material covering the optical waveguide 29c is connected to a semiconductor chip of a partner of an optical communication. The semiconductor chip of the partner of the optical communication may be set on the same substrate or another substrate. It is to be noted that any optical adhesive is filled in a space between the SELFOC lenses 28a, 28b, thereby preventing humidity and dust from entering thereinto. If employing such an optical coupling system, laser beam is once collimated so that a large coupling efficiency margin on any positional difference can be set larger.

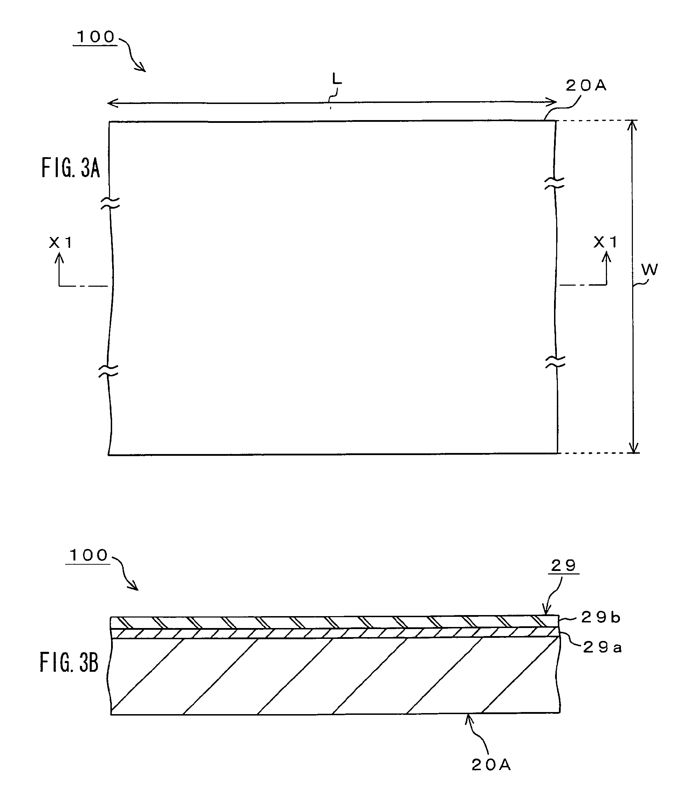

The following will describe a method of manufacturing the embodiment of the optical communication device 100 according to the invention. FIGS. 3A, 4A, 5A, 6A, 7A and 8 show a manufacturing example (No. 1 to No. 6) of the optical communication device 100 and FIGS. 3B, 4B, 5B, 6B and 7B show a schematic section of the optical communication device 100 taken along the lines X1-X1, respectively, shown in FIGS. 3A, 4A, 5A, 6A and 7A.

In this embodiment, it is assumed that the optical communication device 100 is manufactured which performs the optical communication by connecting to the optical fiber 29 the semiconductor chip 10 having the wireless communication circuit elements connected to the antennas 12 and 13. A case is illustrated where an already existing semiconductor chip 10 in which the antennas 12 and 13 are connected to the wireless communication circuit elements is used.

Under these manufacturing conditions, first, an insulating substrate material 20A, which will form a printed wiring board, having a scale as shown in FIG. 3A is prepared. The insulating substrate material 20A has a width of W and a length of L. Low refractive material 29a and high refractive material 29b are layered on the insulating substrate material 20A in this order as shown in FIG. 3B. As the low refractive material 29a and the high refractive material 29b, polymer material for the optical waveguide is used. For example, the low refractive material 29a and the high refractive material 29b each having a predetermined thickness are obtained by applying optical polyimide ink (OPI) made by HITACHI CHEMICAL CO. LTD onto the insulating substrate material 20A.

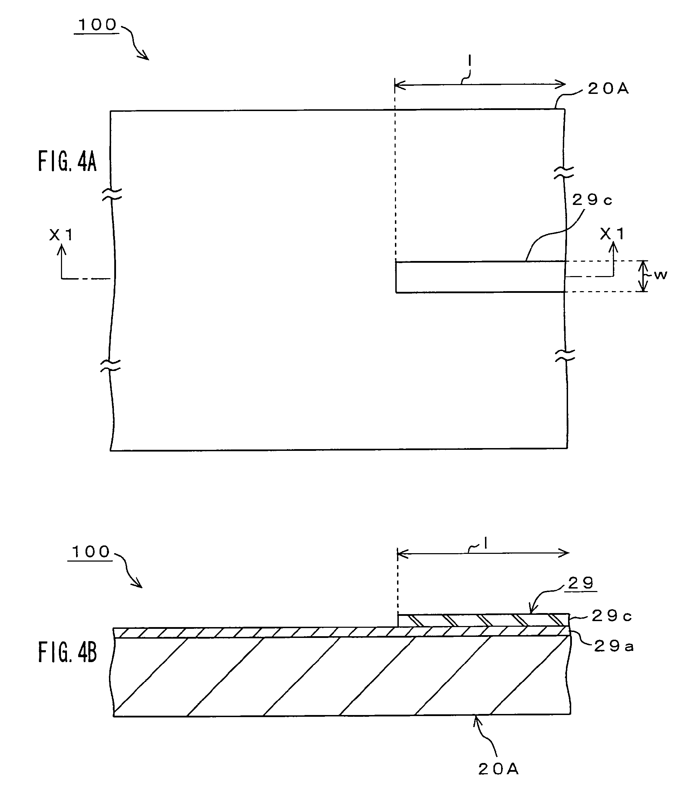

The high refractive material 29b on the low refractive material 29a as shown in FIG. 3B is patterned so as to form an optical waveguide 29c having a width, "w" and a length, "1" as shown in FIG. 4A. For example, photoresist is applied over the whole surface of the high refractive material 29b and a pattern of the optical waveguide 29c is projected on the photoresist using a dry plate (reticle). The photoresist is then exposed and developed and by using a photoresist film thus formed as a mask, unnecessary portion of the high refractive material 29b on the low refractive material 29a is removed by any dry etching (anisotropic etching) or the like. This enables the optical waveguide 29c as shown in FIG. 4B to be obtained. The optical waveguide 29c and the low refractive material 29a constitute the optical fiber 29 in the printed wiring board. The optical fiber 29 connects another optical fiber out of the printed wiring board.

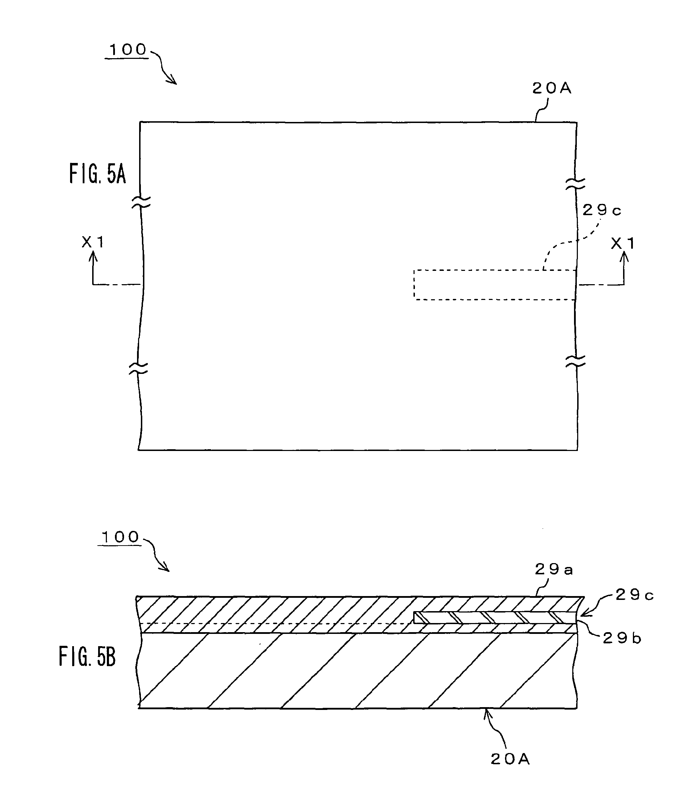

Low refractive material 29a is formed on the optical waveguide 29c having a width, "w" and a length, "1" as shown in FIG. 4A. The low refractive material 29a is planarized as shown in FIG. 5A. Such a planarization is employed because an upper surface of the low refractive material 29a is used as a printed wiring board. A copper thin film is adhered to the printed wiring board by a well-known method and photoresist is applied over the whole surface of the copper thin film. A wiring pattern is projected on the photoresist using a dry plate (reticle). The photoresist is then exposed and developed and by using a photoresist film thus formed as a mask, unnecessary portion of the copper thin film on the low refractive material 29a is removed by any dry etching (anisotropic etching) or the like. This enables the insulating substrate material 20A with printed wiring, not shown, in which the optical waveguide 29c is embedded to be obtained.

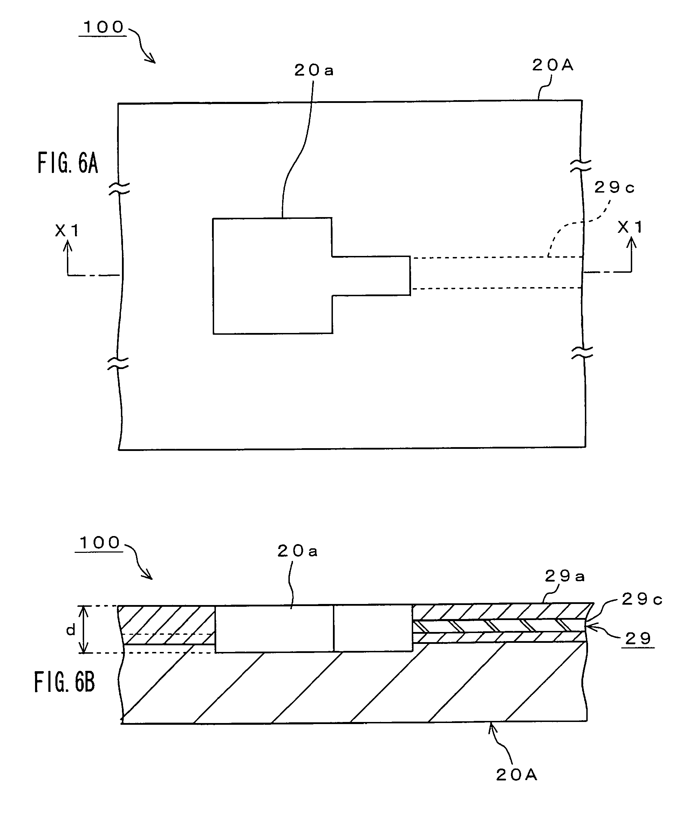

Next, a recess portion 20a having a depth, "d" is formed in a predetermined position of the insulating substrate material 20A with the printed wiring, in which the optical waveguide 29c is embedded as shown in FIG. 5B so as to become an arrangement space of the RF-OPT chip 21 and the lenses 28. The recess portion 20a has a convex opening portion as shown in FIG. 6A. Relating to the recess portion 20a, for example, photoresist is applied over the whole surface of the low refractive material 29a. A recess pattern having a convex shape is projected on the photoresist using a dry plate (reticle). The photoresist is then exposed and developed and by using a photoresist film thus formed as a mask, unnecessary portion of the low refractive material 29a is removed by any dry etching (anisotropic etching) or the like. This enables the insulating substrate material 20A with the convex opened recess portion 20a having the depth, "d" as shown in FIG. 6B to be obtained.

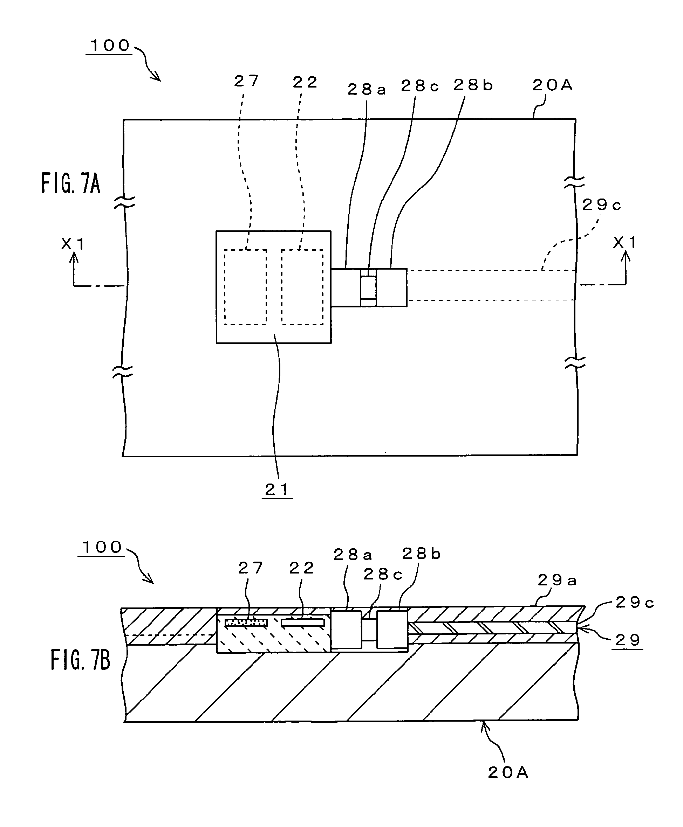

Further, the recess portion 20a shown in FIG. 6B receives the RF-OPT chip 21 and the lenses 28 as shown in FIG. 7A which are embedded to connect the optical waveguide 29c. The RF-OPT chip 21 contains antennas 22, 27 that perform wireless communication to the semiconductor chip 10, wireless communication circuit elements, and optical communication elements that perform optical communication between each of the wireless communication circuit elements and the optical fiber 29. The wireless communication circuit elements include a reception unit 23 and a transmission unit 26, as shown in FIG. 9. The optical communication elements include an electric-signal-to-optical-signal conversion element (hereinafter, referred to be as "E/O conversion unit 24) and an optical-signal-to-electric-signal conversion element (hereinafter, referred to be as "O/E conversion unit 25).

In this embodiment, the RF-OPT chip 21 is embedded in a large and extensive part of the recess portion 20a at a left side thereof and the lenses 28 are embedded in a small and narrowed part of the recess portion 20a at a right side thereof. A SELFOC lens 28a constituting the lenses 28 connects a light-emitting port of the RF-OPT chip 21 and an optical waveguide 28c. The other SELFOC lens 28b constituting the lenses 28 connects the optical waveguide 29c. This enables the insulating substrate material 20A to be obtained in which the RF-OPT chip 21 and the lenses 28 are embedded in the recess portion 20a and the lenses 28 connect the optical waveguide 29c. At this time, such an insulating substrate material 20A constitutes the wireless-signal-and-optical-signal conversion chip substrate 20.

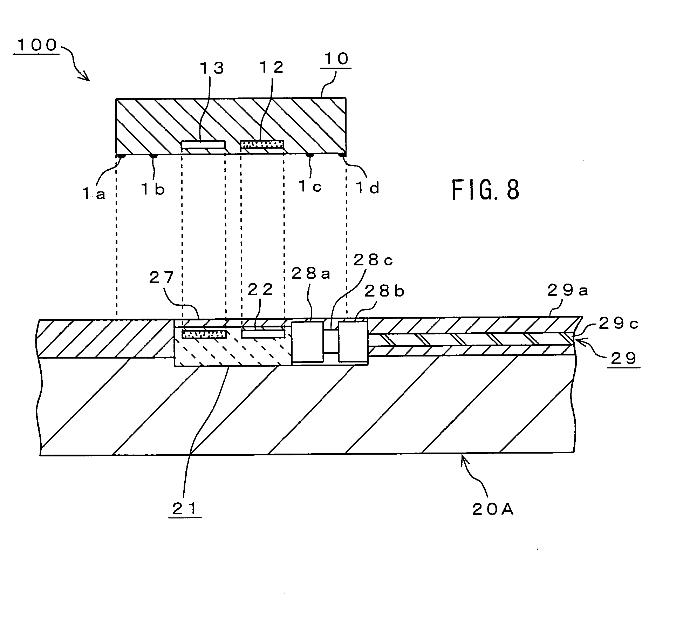

The wireless-signal-and-optical-signal conversion chip substrate 20 containing the RF-OPT chip 21, the lenses 28, and the optical waveguide 29c as shown in FIG. 7A mounts the semiconductor chip 10. The semiconductor chip 10 has a plurality of bump electrodes 1a, 1b, 1c, 1d, and so on for connecting a wiring pattern on a bottom surface thereof. In this embodiment, as shown in FIG. 8, the wireless-signal-and-optical-signal conversion chip substrate 20 mounts the semiconductor chip 10 so that the antenna 12 of the semiconductor chip 10 and the antenna 22 of the RF-OPT chip 21 can be aligned so as to be faced with each other and the antenna 13 of the semiconductor chip 10 and the antenna 27 of the RF-OPT chip 21 can be aligned so as to be faced with each other.

At this time, the plurality of bump electrodes 1a, 1b, 1c, 1d, and so on of the semiconductor chip 10 are connected to the wiring pattern on the wireless-signal-and-optical-signal conversion chip substrate 20 according to the flip chip solder bonding. This enables to be realized the optical communication device 100, as shown in FIGS. 1 and 2, mounting the semiconductor chip 10, the RF-OPT chip 21, the lenses 28, and the optical waveguide 29c on the same substrate.

Thus, according to an embodiment of the method of manufacturing the optical communication device 100 according to the present invention, it is possible to realize the semiconductor-chip-to-optical-fiber interconnection between the semiconductor chip 10 and the optical fiber 29 according to a wireless-to-optical connection at only one connection step. Accordingly, it is possible to manufacture the optical communication device 100 with a high-speed optical interface, which is possible to send or receive at a high speed the signal converted from electric signal to the optical signal and vice versa between the semiconductor chip 10 and the RF-OPT chip 21. If, moreover, the RF-OPT chip 21 is previously arranged in the wireless-signal-and-optical-signal conversion chip substrate 20, then the assembly steps may be carried out in the same apparatus as a past one without any changing the past method.

The following will describe an operation example of the optical communication device 100 when the wireless-signal-and-optical-signal conversion chip substrate 20 connects the semiconductor chip 10 within wireless communication. FIG. 9 shows the operation example of the optical communication device 100 when the wireless-signal-and-optical-signal conversion chip substrate 20 connects the semiconductor chip 10 within wireless communication. The optical communication device 100 shown in FIG. 9 is constituted by connecting the wireless-signal-and-optical-signal conversion chip substrate 20 and the semiconductor chip 10 within wireless communication.

The semiconductor chip 10 includes a transmission unit 11, the antennas 12, 13, a reception unit 14 and a signal-processing unit 15. The transmission unit 11 and the reception unit 14 constitute the wireless communication circuit element and perform any wireless communication to the RF-OPT chip 21 of the wireless-signal-and-optical-signal conversion chip substrate 20. The signal-processing unit 15 prepares transmission data D11 to be transmitted to a partner of the optical communication and transmits the transmission data D11 to the transmission unit 11. The transmission unit 11 connected to the signal-processing unit 15 modulates the transmission data D11 based on a predetermined modulation system to an RF signal S11 and transmits the RF signal S11. The antenna 12 connected to the transmission unit 11 is arranged so as to be faced with the antenna 22 of the wireless-signal-and-optical-signal conversion chip substrate 20. The antenna 12 emits (radiates) electric wave based on the RF signal S11 to the antenna 22.

The RF-OPT chip 21 includes the antenna 22, a reception unit 23, the E/O conversion unit 24, the O/E conversion unit 25, a transmission unit 26 and the antenna 27. The reception unit 23 and the transmission unit 26 constitute the wireless communication circuit element and perform any wireless communication to the semiconductor chip 10. The antenna 22 is arranged so as to be faced with the antenna 12 of the semiconductor chip 10 and receives the electric wave, based on the RF signal S11, which is emitted from the antenna 12 of the semiconductor chip 10. The antenna 22 is connected to the reception unit 23 which receives the RF signal S11 from the semiconductor chip 10 and demodulates it. The reception unit 23 is connected to the E/O conversion unit 24 which converts the demodulated RF signal S11 to collimated light (downward light). The optical fiber 29 connected to the E/O conversion unit 24 guides the collimated light toward a semiconductor chip of the partner of the optical communication.

The optical fiber 29 guides collimated light (upward light) from the semiconductor chip of the partner of the optical communication to the O/E conversion unit 25. The O/E conversion unit 25 converts the collimated light to an RF signal S12. The O/E conversion unit 25 is connected to the transmission unit 26. The transmission unit 26 modulates an electric signal according to a predetermined modulation system to the RF signal S12 and transmits the RF signal S12. The antenna 27 connected to the transmission unit 26 is arranged so as to be faced with the antenna 13 of the semiconductor chip 10. The antenna 27 emits (radiates) electric wave based on the RF signal S12 to the antenna 13.

The reception unit 14 connected to the antenna 13 of the semiconductor chip 10 receives the RF signal S12 from the RF-OPT chip 21 and demodulates the RF signal S12 to reception data D12. The demodulated reception data D12 is transmitted to the signal-processing unit 15. The signal-processing unit 15 performs signal input processing on the reception data D12 received from the partner of the optical communication. This enables the optical communication to be realized between the optical communication device 100 and an optical communication device of the partner of the optical communication. According to the operation example of the optical communication device 100, in a downward optical communication processing, the transmission data D11 transmitted from the signal-processing unit 15 is modulated and the modulated downward RF signal S11 is converted to a downward optical signal along a transmission route of the wireless communication transmission unit 11 and the antenna 12 of the semiconductor chip 10, and the antenna 22, the wireless communication reception unit 23, the E/O conversion unit 24 and the optical fiber 29 of the wireless-signal-and-optical-signal conversion chip substrate 20 in this order.

According to the operation example of the optical communication device 100, in an upward optical communication processing, an upward optical signal from the optical communication device of the partner of the optical communication is converted to the upward RF signal S12 along a reception route of the optical fiber 29, the O/E conversion unit 25, the wireless communication transmission unit 26 and the antenna 27 of the wireless-signal-and-optical-signal conversion chip substrate 20 and the antenna 13 and the wireless communication reception unit 14 of the semiconductor chip 10 in this order. The upward RF signal S12 is demodulated to become data D12 and the demodulated data D12 is inputted to the signal-processing unit 15.

Thus, in the embodiment of the optical communication device 100 according to the invention, the E/O conversion unit 24 can convert the rapid RF signal S11, which is received by the antenna 22 and the reception unit 23 of the RF-OPT chip 21 within wireless communication under the semiconductor chip 10, to the collimated light and can emit the collimated light to the optical fiber 29 or the O/E conversion unit 25 of the RF-OPT chip 21 can convert the collimated light, which is received from the optical communication device of the partner of the optical communication through the optical fiber 29 under the semiconductor chip 10, to the RF signal S12 and transmit it to the transmission unit 26 which performs wireless transmission processing on it together with the antenna 27 of the wireless-signal-and-optical-signal conversion chip substrate 20.

Accordingly, it is possible to connect the already existing semiconductor chip 10 built-in the antennas to the optical fiber 29 of the wireless-signal-and-optical-signal conversion chip substrate 20 easily through the RF-OPT chip 21 under the semiconductor chip 10. This enables to be presented the optical communication device 100 with a high-speed optical interface that converts the electrical signal to the optical signal or vice versa to perform transmission and/or reception of the converted one at a high speed between the semiconductor chip 10 and the RF-OPT chip 21.

### [Embodiment 2]

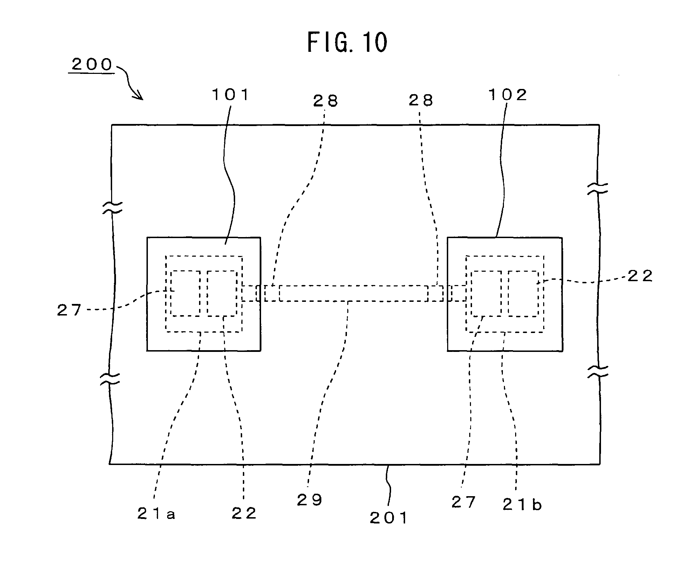

FIG. 10 shows a configuration of an optical communication device 200 as a second embodiment of the invention. The optical communication device 200 shown in FIG. 10 contains a wireless-signal-and-optical-signal conversion chip substrate 201, two semiconductor chips 101, 102 which are mounted on the wireless-signal-and-optical-signal conversion chip substrate 201, and an optical fiber 29 in the wireless-signal-and-optical-signal conversion chip substrate 201. The optical fiber 29 connects the two semiconductor chips 101, 102. As each of the two semiconductor chips 101, 102, the semiconductor chip 10 described in the first embodiment is used.

An RF-OPT chip 21a, antennas 22, 27, and lenses 28 are provided under the semiconductor chip 101 and an RF-OPT chip 21b, antennas 22, 27, and lenses 28 are also provided under the semiconductor chip 102. The semiconductor chip 102 is a partner of the optical communication of the semiconductor chip 101 and inputs or outputs other RF signals S11, S12 at a high speed.

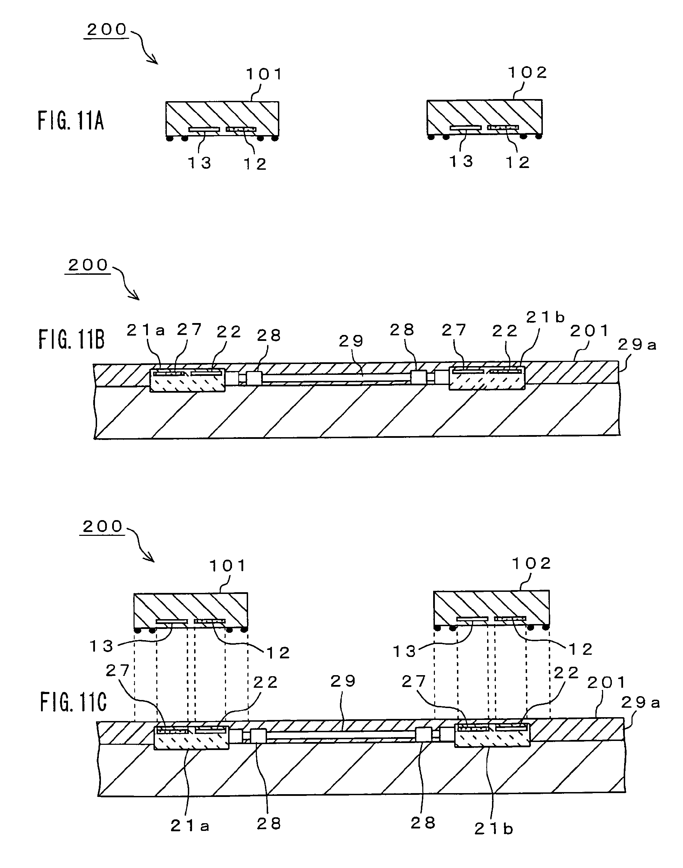

FIGS. 11A through 11C respectively show a manufacturing example of the optical communication device 200. The two semiconductor chips 101, 102 shown in FIG. 11A are first prepared. As each of the semiconductor chips 101, 102, an already existing semiconductor chip with a wireless communication function, which can input or output the RF signals S11, S12 at a high speed may be used in addition to the semiconductor chip 10 described in the first embodiment. The semiconductor chips 101, 102 respectively have the antennas 12, 13 at their bottom surface sides. The semiconductor chips 101, 102 respectively have bump electrodes for connecting a wiring pattern at their bottom surface.

Next, the wireless-signal-and-optical-signal conversion chip substrate 201 shown in FIG. 11B is prepared. The wireless-signal-and-optical-signal conversion chip substrate 201 has a configuration, which is similar to that of the wireless-signal-and-optical-signal conversion chip substrate 20 described in the first embodiment, and includes pairs of the RF-OPT chips 21a, 21b, the antennas 22, the antennas 27, and the lenses 28. The optical fiber 29 connects the lenses 28. The wireless-signal-and-optical-signal conversion chip substrate 201 also constitutes the printed wiring board, which is similar to that of the first embodiment. The detailed description of the wireless-signal-and-optical-signal conversion chip substrate 201 will be omitted because a method of manufacturing the wireless-signal-and-optical-signal conversion chip substrate 201 is similar to that of the wireless-signal-and-optical-signal conversion chip substrate 20 of the first embodiment.

Further, the wireless-signal-and-optical-signal conversion chip substrate 201 mounts the two semiconductor chips 101, 102, respectively, as shown in FIG. 11C. In this embodiment, as shown in FIG. 11C, at one side of the wireless-signal-and-optical-signal conversion chip substrate 201, the wireless-signal-and-optical-signal conversion chip substrate 201 mounts the semiconductor chips 101 so that the antenna 12 of the semiconductor chip 101 and the antenna 22 of the RF-OPT chip 21a can be aligned so as to be faced with each other and the antenna 13 of the semiconductor chip 101 and the antenna 27 of the RF-OPT chip 21a can be aligned so as to be faced with each other.

At the other side of the wireless-signal-and-optical-signal conversion chip substrate 201, the wireless-signal-and-optical-signal conversion chip substrate 201 mounts the semiconductor chips 102 so that the antenna 12 of the semiconductor chip 102 and the antenna 22 of the RF-OPT chip 21b can be aligned so as to be faced with each other and the antenna 13 of the semiconductor chip 102 and the antenna 27 of the RF-OPT chip 21b can be aligned so as to be faced with each other. At this time, bump electrodes of each of the semiconductor chips 101, 102 are connected to the wiring pattern on the wireless-signal-and-optical-signal conversion chip substrate 201 according to a flip chip solder bonding. This enables to be realized the optical communication device 200, as shown in FIG. 10, in which the same wireless-signal-and-optical-signal conversion chip substrate 201 mounts the semiconductor chips 101, 102, the RF-OPT chips 21a, 21b, the lenses 28, and the optical fiber 29.

In this embodiment, according to the operation example of the optical communication device 200, in a downward optical communication processing, the rapid downward RF signal S11 is transmitted from the semiconductor chip 101 to the RF-OPT chip 21a of the wireless-signal-and-optical-signal conversion chip substrate 201 within wireless communication through the antenna 12 of the semiconductor chip 101 and the antenna 22 of the wireless-signal-and-optical-signal conversion chip substrate 201. The RF-OPT chip 21a converts the RF signal S11 to the collimated light so that the downward light thus converted is transmitted to the RF-OPT chip 21b through the optical fiber 29. The RF-OPT chip 21b converts the downward light to the RF signal S11.

The converted RF signal S11 becomes a rapid downward RF signal S11 along a reception route of the antenna 27 of the RF-OPT chip 21b, the antenna 13 of the semiconductor chip 102, and the semiconductor chip 102 in this order. This enables to be realized the downward optical communication from the semiconductor chip 101 to the semiconductor chip 102 through the optical fiber 29 in the wireless-signal-and-optical-signal conversion chip substrate 201.

Further, in an upward optical communication processing of the optical communication device 200, a rapid upward RF signal S12 from the semiconductor chip 102 of the partner of the optical communication is transmitted to the RF-OPT chip 21b of the wireless-signal-and-optical-signal conversion chip substrate 201 within wireless communication through the antenna 12 of the semiconductor chip 102 and the antenna 22 of the wireless-signal-and-optical-signal conversion chip substrate 201. The RF-OPT chip 21b converts the RF signal S12 to the collimated light (upward light) so that the converted upward light is transmitted to the RF-OPT chip 21a through the optical fiber 29.

The RF-OPT chip 21a converts the upward light to the rapid RF signal S12. The converted RF signal S12 becomes a rapid upward RF signal S12 along a reception route of the antenna 27 of the RF-OPT chip 21a, the antenna 13 of the semiconductor chip 101, and the semiconductor chip 101 in this order. This enables to be realized the upward optical communication from the semiconductor chip 102 to the semiconductor chip 101 through the optical fiber 29 in the wireless-signal-and-optical-signal conversion chip substrate 201.

Thus, in the embodiments of the optical communication device 200 and the method of manufacturing the same according to the invention, the wireless-signal-and-optical-signal conversion chip substrate 201 mounts the two semiconductor chips 101, 102, respectively, and the optical fiber 29 in the wireless-signal-and-optical-signal conversion chip substrate 201 connects these two semiconductor chips 101, 102. Accordingly, it is possible to perform the optical communication between these two semiconductor chips 101, 102 that are arranged in a straight line as shown in FIG. 10.

### [Embodiment 3]

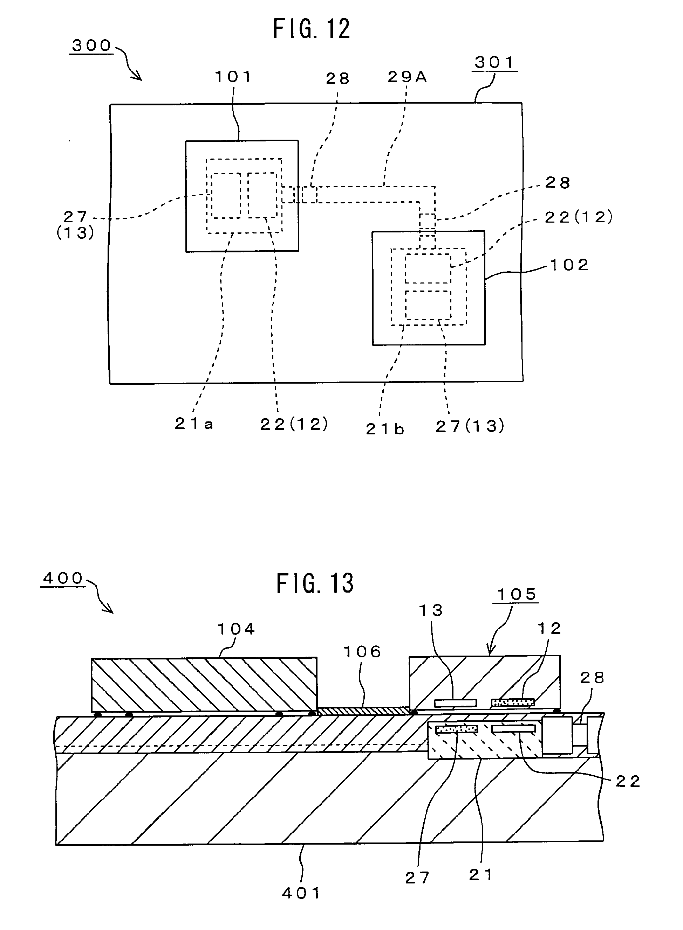

FIG. 12 shows a configuration of an optical communication device 300 as a third embodiment of the invention. The optical communication device 300 shown in FIG. 12 contains a wireless-signal-and-optical-signal conversion chip substrate 301, two semiconductor chips 101, 102 which are mounted on the wireless-signal-and-optical-signal conversion chip substrate 301, and an L-shaped bent optical fiber 29A in the wireless-signal-and-optical-signal conversion chip substrate 301. The L-shaped bent optical fiber 29A connects the two semiconductor chips 101, 102. As each of the two semiconductor chips 101, 102, the semiconductor chip 10 described in the first embodiment is used.

In this embodiment, an RF-OPT chip 21a, antennas 22, 27, and lenses 28 are provided under the semiconductor chip 101, which is similar to the second embodiment, and an RF-OPT chip 21b, antennas 22, 27, and lenses 28 are also provided under the semiconductor chip 102, which is also similar to the second embodiment. The semiconductor chip 102 is a partner of the optical communication of the semiconductor chip 101 and inputs or outputs other RF signals S11, S12 at a high speed. It is to be noted that the detailed description of a method of manufacturing the wireless-signal-and-optical-signal conversion chip substrate 301 will be omitted because the method of manufacturing the wireless-signal-and-optical-signal conversion chip substrate 301 is similar to that of the wireless-signal-and-optical-signal conversion chip substrate 201 of the second embodiment excluding that the L-shaped bent optical fiber 29A is formed in the wireless-signal-and-optical-signal conversion chip substrate 301.

Thus, according to the embodiment of the optical communication device 300 according to the invention, it is possible to enhance freedom in a layout design of the semiconductor chips 101, 102, as compared by that of the second embodiment, because the semiconductor chip 102 can be arranged on a position that is bent L-shaped, not straight, with respect to the mounted position of the semiconductor chip 101. [Embodiment 4]

FIG. 13 shows a configuration of an optical communication device 400 as a fourth embodiment of the invention. In this embodiment, there is a specified RF signal and data conversion chip 105 that converts transmission data D11 to an RF signal S11 or converts an RF signal S12 to reception data D12, which enables optical communication processing to be carried out by connecting an optical fiber through a wireless-signal-and-optical-signal conversion chip substrate 401 even if a semiconductor chip 104 has no wireless communication function.

The optical communication device 400 shown in FIG. 13 contains the wireless-signal-and-optical-signal conversion chip substrate 401, the semiconductor chip 104 and the specified RF signal and data conversion chip 105. The wireless-signal-and-optical-signal conversion chip substrate 401 mounts the semiconductor chip 104 and the specified RF signal and data conversion chip 105. A wiring pattern 106 connects the semiconductor chip 104 and the specified RF signal and data conversion chip 105. The specified RF signal and data conversion chip 105 and an RF-OPT chip 21 in the wireless-signal-and-optical-signal conversion chip substrate 401 are connected within wireless communication, so that the optical communication device 400 can be connected to a semiconductor chip of a partner of the optical communication through the optical fiber. As the semiconductor chip 104, the semiconductor chip 10 having any wireless communication function, which has been described in the first embodiment, is not used but a regular semiconductor chip having no wireless communication function is used.

The specified RF signal and data conversion chip 105 contains antennas 12, 13. The specified RF signal and data conversion chip 105 also contains the transmission unit 11 and the reception unit 14, which are shown in FIG. 9 but not shown in FIG. 13. The specified RF signal and data conversion chip 105 performs wireless communication to the RF-OPT chip 21 in the wireless-signal-and-optical-signal conversion chip substrate 401. The antenna 12 is arranged so as to be faced with the antenna 22 of the wireless-signal-and-optical-signal conversion chip substrate 401. The antenna 12 emits (radiates) electric wave based on the RF signal S11 to the antenna 22.

An RF-OPT chip 21, the antennas 22, 27, and lenses 28 are provided in the wireless-signal-and-optical-signal conversion chip substrate 401 under the specified RF signal and data conversion chip 105. The RF-OPT chip 21 is connected to a semiconductor chip, which inputs or outputs other rapid RF signals S11, S12, of a partner of the optical communication of the semiconductor chip 104 through an optical fiber, not shown in FIG. 13. This enables the optical communication processing to other semiconductor chip through the wireless-signal-and-optical-signal conversion chip substrate 401 to be realized in the semiconductor chip 104 having no wireless communication function.

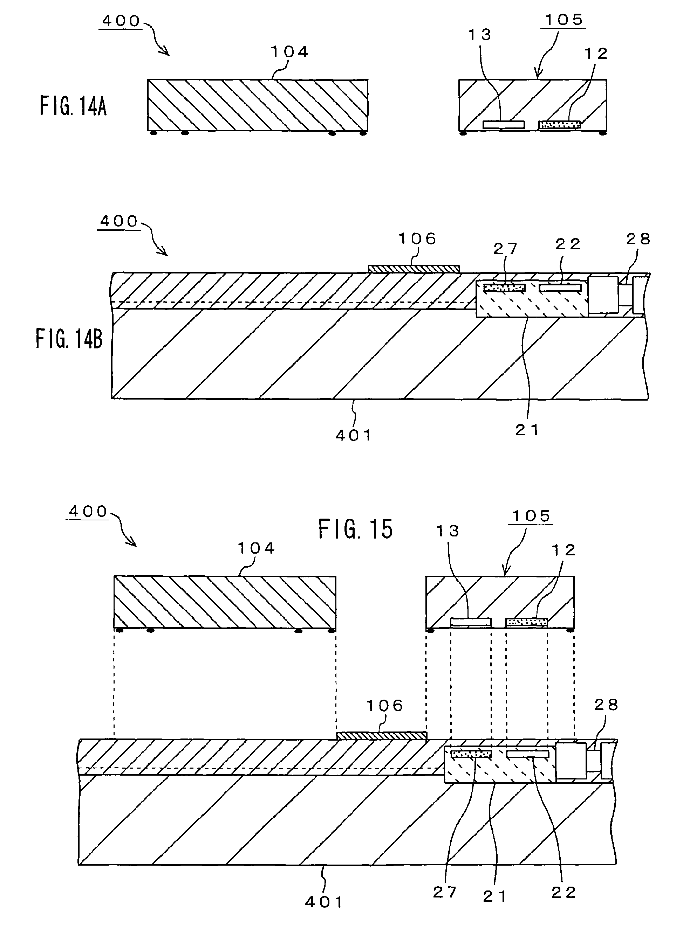

The following will describe a method of manufacturing the embodiment of the optical communication device 400 according to the invention. FIGS. 14A, 14B and 15 show a manufacturing example (Nos. 1 and 2) of the optical communication device 400. The semiconductor chip 104 and the specified RF signal and data conversion chip 105, which are shown in FIG. 14A, are first prepared. As the semiconductor chip 104, the semiconductor chip having any wireless communication function, which has been described in the first embodiment, is not used but a regular semiconductor chip having no wireless communication function is used. The specified RF signal and data conversion chip 105 has the antennas 12, 13 at its bottom surface side. The specified RF signal and data conversion chip 105 has bump electrodes for connecting a wiring pattern and an extraction electrode at its bottom and side surfaces.

Next, the wireless-signal-and-optical-signal conversion chip substrate 401 shown in FIG. 14B is prepared. The wireless-signal-and-optical-signal conversion chip substrate 401 has a configuration, which is similar to that of the wireless-signal-and-optical-signal conversion chip substrate 20 described in the first embodiment, and includes the RF-OPT chip 21, the antennas 22, 27, and the lenses 28. The optical fiber, not shown, connects a tip of the lenses 28. The wireless-signal-and-optical-signal conversion chip substrate 401 also constitutes the printed wiring board, which is similar to that of the first embodiment. The wiring pattern 106 for connecting the semiconductor chip 104 and the specified RF signal and data conversion chip 105 is formed on the wireless-signal-and-optical-signal conversion chip substrate 401. The wiring pattern 106 is formed so as to be same as the connection wiring pattern of the semiconductor chip 104. The detailed description of the wireless-signal-and-optical-signal conversion chip substrate 401 will be omitted because a method of manufacturing the wireless-signal-and-optical-signal conversion chip substrate 401 is similar to that of the wireless-signal-and-optical-signal conversion chip substrate 20 of the first embodiment.

Further, the wireless-signal-and-optical-signal conversion chip substrate 401 mounts the semiconductor chip 104 and the specified RF signal and data conversion chip 105, as shown in FIG. 15. In this embodiment, as shown in FIG. 15, at one side of the wireless-signal-and-optical-signal conversion chip substrate 401, the wireless-signal-and-optical-signal conversion chip substrate 401 mounts the semiconductor chips 104 which is connected to the wiring pattern 106. At the other side of the wireless-signal-and-optical-signal conversion chip substrate 401, the wireless-signal-and-optical-signal conversion chip substrate 401 mounts the specified RF signal and data conversion chip 105 so that the antenna 12 of the specified RF signal and data conversion chip 105 and the antenna 22 of the RF-OPT chip 21 can be aligned so as to be faced with each other and the antenna 13 of the specified RF signal and data conversion chip 105 and the antenna 27 of the RF-OPT chip 21 can be aligned so as to be faced with each other.

At this time, bump electrodes of the semiconductor chip 104 are connected to a wiring pattern on the wireless-signal-and-optical-signal conversion chip substrate 401 according to, for example, the flip chip solder bonding. In the same manner, bump electrodes of the specified RF signal and data conversion chip 105 are connected to a wiring pattern on the wireless-signal-and-optical-signal conversion chip substrate 401. This enables to be realized the optical communication device 400, as shown in FIG. 13, which includes the wireless-signal-and-optical-signal conversion chip substrate 401 mounting the semiconductor chip 104 and the specified RF signal and data conversion chip 105.

In this embodiment, according to the operation example of the optical communication device 400, in a downward optical communication processing, the semiconductor chip 104 transmits the transmission data D11 to the specified RF signal and data conversion chip 105. The specified RF signal and data conversion chip 105 modulates the transmission data D11 to a rapid downward RF signal S11. The modulated rapid downward RF signal S11 is transmitted within wireless communication along a route of the antenna 12 of the specified RF signal and data conversion chip 105, the antenna 22 of the wireless-signal-and-optical-signal conversion chip substrate 401 and the RF-OPT chip 21 thereof in this order. The RF-OPT chip 21 converts the RF signal S11 to the collimated light so that the downward light is transmitted to the semiconductor chip of the partner of the optical communication through the optical fiber. This enables to be realized the downward optical communication via the specified RF signal and data conversion chip 105 through the optical fiber in the wireless-signal-and-optical-signal conversion chip substrate 401.

Further, in an upward optical communication processing of the optical communication device 400, upward light from the semiconductor chip of the partner of the optical communication is transmitted to the RF-OPT chip 21 of the wireless-signal-and-optical-signal conversion chip substrate 401 through the optical fiber of the wireless-signal-and-optical-signal conversion chip substrate 401. The RF-OPT chip 21 converts the upward light to the rapid electric (RF) signal S12. The converted RF signal S12 becomes a rapid upward RF signal S12 along a reception route of the antenna 27 of the RF-OPT chip 21 and the antenna 13 of the specified RF signal and data conversion chip 105. The upward RF signal S12 is demodulated and the demodulated upward RF signal S12 is converted to digital reception data D12, which is transmitted to the semiconductor chip 104 through the wiring pattern 106. This enables the semiconductor chip 104 to perform the upward optical communication processing via the specified RF signal and data conversion chip 105 through the optical fiber 29 in the wireless-signal-and-optical-signal conversion chip substrate 401.

Thus, in the embodiments of the optical communication device 400 and the method of manufacturing the same according to the invention, the wireless-signal-and-optical-signal conversion chip substrate 401 mounts the semiconductor chip 104 and the specified RF signal and data conversion chip 105. The wiring pattern 106 connects the semiconductor chip 104 and the specified RF signal and data conversion chip 105. The specified RF signal and data conversion chip 105 and the RF-OPT chip 21 in the wireless-signal-and-optical-signal conversion chip substrate 401 are connected within wireless communication. The RF-OPT chip 21 is connected to the semiconductor chip of the partner of the optical communication through the optical fiber 29 in the wireless-signal-and-optical-signal conversion chip substrate 401.

Accordingly, the specified RF signal and data conversion chip 105 converts the transmission data D11 to the RF signal S11 and transmits the converted RF signal S11 to the RF-OPT chip 21, so that the semiconductor chip 104 having no wireless communication can be also connected to the optical fiber 29 in the wireless-signal-and-optical-signal conversion chip substrate 401, which is similar to that of each of the first through third embodiments of the invention, thereby enabling the optical communication processing to the other semiconductor chip that inputs or outputs the rapid RF signals S11, S12 to be realized. [Embodiment 5]

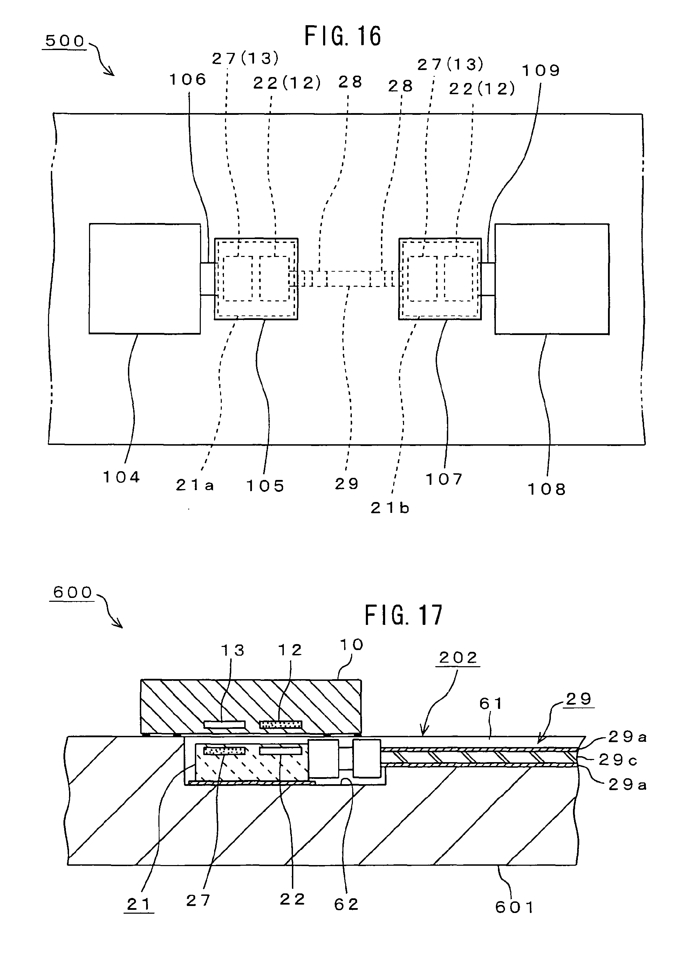

FIG. 16 shows a configuration of an optical communication device 500 as a fifth embodiment of the invention. The optical communication device 500 shown in FIG. 16 contains the wireless-signal-and-optical-signal conversion chip substrate 501, the semiconductor chips 104, 108 which have no wireless communication function, and the specified RF signal and data conversion chips 105, 107. The wireless-signal-and-optical-signal conversion chip substrate 501 mounts the semiconductor chips 104, 108. The semiconductor chips 104, 108 are connected through the specified RF signal and data conversion chips 105, 107 on the wireless-signal-and-optical-signal conversion chip substrate 501 and the optical fiber 29 arranged in a straight line in the wireless-signal-and-optical-signal conversion chip substrate 501. As each of the semiconductor chips 104, 108, the semiconductor chip having any wireless communication function, which has been described in the first embodiment, is not used but a regular semiconductor chip having no wireless communication function is used.

In this embodiment, a wiring pattern 106 connects the semiconductor chip 104 and the specified RF signal and data conversion chip 105. The specified RF signal and data conversion chip 105 and an RF-OPT chip 21 in the wireless-signal-and-optical-signal conversion chip substrate 501 are connected within wireless communication, so that the optical communication device 500 can be connected to a semiconductor chip of a partner of the optical communication through the optical fiber 29. An RF-OPT chip 21a, the antennas 22, 27, and lenses 28 are provided in the wireless-signal-and-optical-signal conversion chip substrate 501 under the specified RF signal and data conversion chip 105, which is similar to that of the fourth embodiment of the invention. An RF-OPT chip 21b, the antennas 22, 27, and lenses 28 are provided in the wireless-signal-and-optical-signal conversion chip substrate 501 under the specified RF signal and data conversion chip 107, which is similar to that of the fourth embodiment of the invention (see FIG. 9).

A wiring pattern 109 connects the semiconductor chip 108 and the specified RF signal and data conversion chip 107. The specified RF signal and data conversion chip 107 and an RF-OPT chip 21 in the wireless-signal-and-optical-signal conversion chip substrate 501 are connected within wireless communication. The semiconductor chip 108 is a partner of the optical communication of the semiconductor 104 and inputs or outputs the other rapid RF signals S11, S12. It is to be noted that the detailed description of a method of manufacturing the optical communication device 500 will be omitted because the method of manufacturing the optical communication device 500 is similar to that described in the fourth embodiment excluding that the specified RF signal and data conversion chips 105, 107 and the wiring patterns 106, 109 are formed above the straight optical fiber 29.

Thus, according to the embodiment of the optical communication device 500 according to the invention, the wireless-signal-and-optical-signal conversion chip substrate 501 mounts the two semiconductor chips 104, 108 having no wireless communication function. The semiconductor chips 104 and the specified RF signal and data conversion chip 105 are connected through wire via the wiring pattern 106 on the wireless-signal-and-optical-signal conversion chip substrate 501. The specified RF signal and data conversion chip 105 and the RF-OPT chip 21 under the specified RF signal and data conversion chip 105 are connected within wireless communication. The RF-OPT chips 21, 21 are optically connected to each other in the wireless-signal-and-optical-signal conversion chip substrate 501 through the optical fiber 29 arranged in a straight line therein. The specified RF signal and data conversion chip 107 and the RF-OPT chip 21 under the specified RF signal and data conversion chip 107 are connected within wireless communication. The specified RF signal and data conversion chip 107 and the semiconductor chips 108 are connected through wire via the wiring pattern 109 on the wireless-signal-and-optical-signal conversion chip substrate 501.

Accordingly, it is possible to connect the two semiconductor chips 104, 108 through the specified RF signal and data conversion chips 105, 107 on the wireless-signal-and-optical-signal conversion chip substrate 501 and the optical fiber 29 arranged in a straight line in the wireless-signal-and-optical-signal conversion chip substrate 501. This enables a restriction in a design of the semiconductor chips 104, 108 having no wireless communication function to be considerably decreased so that freedom in a layout design of the semiconductor chips 104, 108 and the semiconductor chip 102 having any wireless communication function can be enhanced.

It is to be noted that although the cases where all the RF-OPT chips 21, 21a, 21b and the optical fibers 29, 29A are embedded in the wireless-signal-and-optical-signal conversion chip substrates 20, 201, 301, 401 and 501, respectively have been described in the above-mentioned first through fifth embodiments of the invention, the invention is not limited thereto: the RF-OPT chip 21 and the like may be arranged in a recess portion of a wireless-signal-and-optical-signal conversion chip substrates 601, as shown in FIG. 17.

### [Embodiment 6]

FIG. 17 shows a configuration of an optical communication device 600 as a sixth embodiment of the invention. In this embodiment, a wireless-signal-and-optical-signal conversion chip substrate 601 has a trench in which a recess portion 62 is provided at a position where the RF signals S11, S12 can be transmitted or received and a channel is communicated to the recess portion 62. The RF-OPT chip 21 and the optical fiber 29 are arranged within the recess portion 62 and the channel 61.

The optical communication device 600 shown in FIG. 17 is applicable to a high-speed optical interface apparatus which can convert an electrical signal to an optical signal or vice versa to perform transmission and/or reception of the converted one at a high speed between a semiconductor chip and a wireless-signal-and-optical-signal conversion chip. The optical communication device 600 contains a semiconductor chip 10 having any wireless communication function and the wireless-signal-and-optical-signal conversion chip substrate 601. The wireless-signal-and-optical-signal conversion chip substrate 601 mounts the semiconductor chip 10 which inputs or outputs an image signal and/or an audio signal based on a clock signal of a high-speed operation frequency. The semiconductor chip 10 has antennas 12, 13 as described in the first embodiment of the invention.

In this embodiment, the wireless-signal-and-optical-signal conversion chip substrate 601 includes a thick printed wiring board to some degree in which the recess portion 62 for receiving the RF-OPT chip and the channel 61 for receiving the optical fiber are formed. The recess portion 62 receives the RF-OPT chip and the channel 61 receives the optical fiber. The channel 61 is communicated to the recess portion 62. An optical module in which the RF-OPT chip 21, the lenses 28, and the optical fiber 29, which are described in the first embodiment of the invention, are connected to each other is arranged in the recess portion 62 and the channel 61.

The RF-OPT chip 21 has an input/output function of the RF signals S11, S12 and a RF-signal-to-optical-signal conversion function or an optical-signal-to-RF-signal conversion function. The RF-OPT chip 21 converts the RF signal S11 to an optical signal to emit collimated light or converts incident collimated light to an RF signal S12 to transmit the converted one to the semiconductor chip 10 in the wireless communication. The RF-OPT chip 21 has the antenna 22 and the antenna 27. These antennas 22, 27 are respectively connected to the wireless communication circuit elements, which are not shown in FIG. 17, of the RF-OPT chip 21 (see FIG.9).

As described in the first embodiment of the invention, the semiconductor chip 10 is connected to the RF-OPT chip 21, which is set just under the semiconductor chip 10, in the wireless communication via the antennas 12, 22, 13, and 27. In this embodiment, the wireless-signal-and-optical-signal conversion chip substrate 601 mounts the semiconductor chip 10 so that the antenna 12 of the semiconductor chip 10 can be faced with the antenna 22 of the RF-OPT chip 21 and the antenna 13 of the semiconductor chip 10 can be faced with the antenna 27 of the RF-OPT chip 21.

For example, a wiring pattern is formed on an upper surface of the wireless-signal-and-optical-signal conversion chip substrate 601 and the wiring pattern is connected to the semiconductor chip 10. The semiconductor chip 10 is mounted on the wireless-signal-and-optical-signal conversion chip substrate 601 by means of solder-boding, which is similar to that of the first embodiment of the invention. This enables the optical communication device 600 having the trench to be completed.

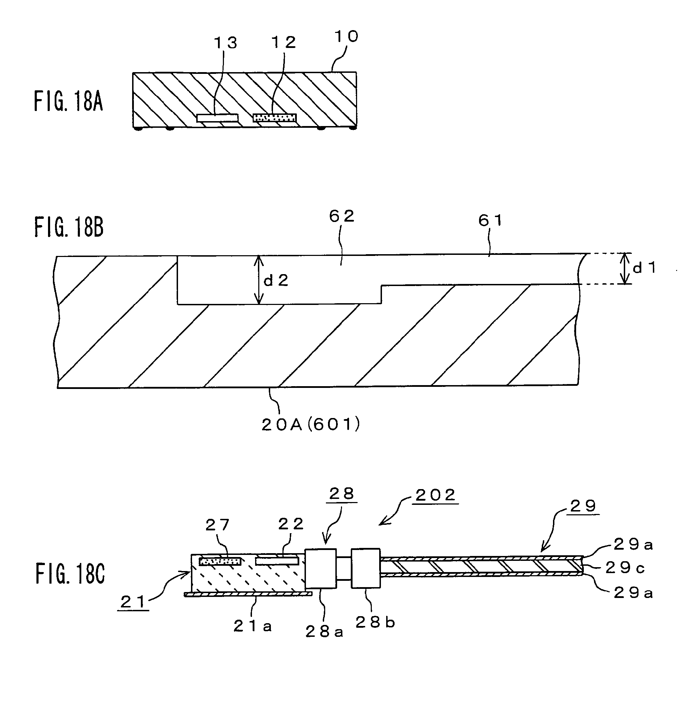

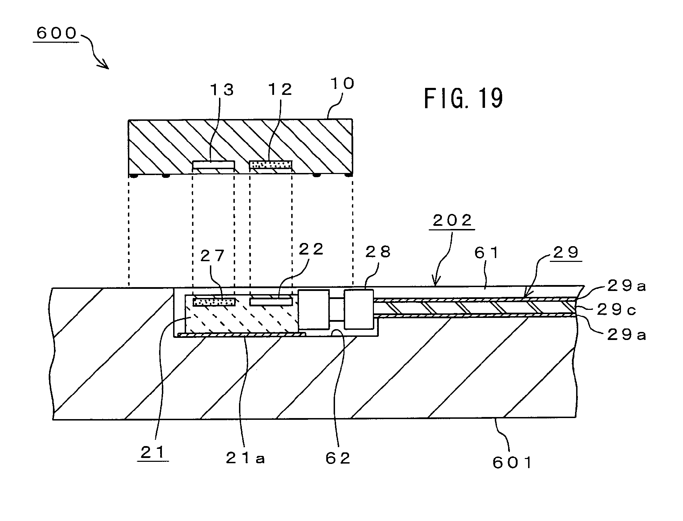

The following will describe a method of manufacturing the embodiment of the optical communication device 600 according to the invention. FIGS. 18A through 18C and 19 show a manufacturing example (Nos. 1 and 2) of the optical communication device 600

In this embodiment, it is assumed that the optical communication device 600, which performs the optical communication, is manufactured by mounting the semiconductor chip 10 having the wireless communication circuit elements connected to the antennas 12 and 13 on the wireless-signal-and-optical-signal conversion chip substrate 601. A case is illustrated where the optical module 202 is constituted by connecting the RF-OPT chip 21, the lenses 28 and the optical fiber 29 to each other and is available.

Under these manufacturing conditions, first, the semiconductor chip 10 shown in FIG. 18A is prepared. As the semiconductor chip 10, the antenna-element-built-in semiconductor chip as described in the first embodiment of the invention is used. Next, the wireless-signal-and-optical-signal conversion chip substrate 601 having the trench shown in FIG. 18B is prepared. As the wireless-signal-and-optical-signal conversion chip substrate 601, the insulating substrate material 20A having a size, which constitutes the printed wiring board, as described in the first embodiment of the invention is used.

As shown in FIG. 18B, the insulating substrate material 20A is then patterned to form the channel 61 having a depth of d1 and the recess portion 62 having a depth of d2 therein by utilizing an existing digging and/or grooving technique. For example, photoresist is applied over the whole surface of the insulating substrate material 20A and open patterns of the recess portion 62 and the channel 61 are projected on the photoresist using a dry plate (reticle) having patterns of the recess portion 62 and the channel 61. The photoresist is then exposed and developed and by using a photoresist film thus formed as a mask, unnecessary portion of the insulating substrate material 20A is removed by any dry etching (anisotropic etching) or the like. This dry etching enables the channel 61 having the depth of d1 and the recess portion 62 to be formed.

In addition to the photoresist film over the whole surface of the insulating substrate material 20A, another photoresist film is further formed in the channel 61 by using the above-mentioned method and by using this photoresist film thus formed as a mask, unnecessary portion of the insulating substrate material 20A in the recess portion 62 is removed by any dry etching or the like. This dry etching enables the recess portion 62 having the depth of d2 to be completed. It is thus possible to obtain the wireless-signal-and-optical-signal conversion chip substrate 601 having the channel 61 having the depth of d1 and the recess portion 62 having the depth of d2, as shown in FIG. 18B, which are different from each other in the depth thereof.

Further, the optical module 202 shown in FIG. 18C is prepared. This optical module 202 is constituted by connecting the RF-OPT chip 21, the lenses 28, and the optical fiber 29 to each other. The RF-OPT chip 21 contains antennas 22, 27 that perform wireless communication to the semiconductor chip 10, wireless communication circuit elements, and optical communication elements that perform optical communication between each of the wireless communication circuit elements and the optical fiber 29. The wireless communication circuit elements include a reception unit 23 and a transmission unit 26, as shown in FIG. 9. The optical communication elements include the E/O conversion unit 24 and the O/E conversion unit 25.

In this embodiment, the lenses 28 are connected to the optical communication elements of the optical module 202. As the lenses 28, SELFOC lenses 28a, 28b. For example, one SELFOC lens 28a is connected to a light-emitting port of the RF-OPT chip 21 and an optical waveguide, not shown, and the other SELFOC lens 28b is connected to the optical waveguide 29c of the optical fiber 29. As the optical fiber 29, the optical fiber in which low refractive material 29a covers the optical waveguide 29c at its outer circumference is used. The optical fiber 29 is connected to, for example, an optical communication device out of the wireless-signal-and-optical-signal conversion chip substrate 601.

The optical module 202 shown in FIG. 18C is then fixed in the recess portion 62 and the channel 61 shown in FIG. 18B. For example, as shown in FIG. 19, the RF-OPT chip 21 and the lenses 28 are set in the recess portion 62 of the wireless-signal-and-optical-signal conversion chip substrate 601 and the optical fiber 29 is set in the channel 61 thereof. At this time, the RF-OPT chip 21 and the lenses 28 are adhered and fixed to the wireless-signal-and-optical-signal conversion chip substrate 601 in the recess portion 62 by adhesive agent and the optical fiber 29 is adhered and fixed to the wireless-signal-and-optical-signal conversion chip substrate 601 in the channel 61 by the adhesive agent. As the adhesive agent, hot melt resin adhesive agent may be used. This enables to be obtained the insulating substrate material 20A in which the RF-OPT chip 21 and the lenses 28 are fixed to the wireless-signal-and-optical-signal conversion chip substrate 601 in the recess portion 62 and the optical fiber 29 is fixed to the wireless-signal-and-optical-signal conversion chip substrate 601 in the channel 61. At this time, the insulating substrate material 20A constitutes the wireless-signal-and-optical-signal conversion chip substrate 601.

As shown in FIG. 19, the wireless-signal-and-optical-signal conversion chip substrate 601 thus obtained having the RF-OPT chip 21, the lenses 28, and the optical fiber 29 aligns and mounts the semiconductor chip 10. The semiconductor chip 10 has bump electrodes for connecting a wiring pattern on its bottom surface. In this embodiment, the wireless-signal-and-optical-signal conversion chip substrate 601 mounts the semiconductor chip 10 so that the antenna 12 of the semiconductor chip 10 and the antenna 22 of the RF-OPT chip 21 can be aligned so as to be faced with each other, as shown in FIG. 19, and the antenna 13 of the semiconductor chip 10 and the antenna 27 of the RF-OPT chip 21 can be aligned so as to be faced with each other, as shown in FIG. 19.

At this time, the bump electrodes of the semiconductor chip 10 are connected to the wiring pattern on the wireless-signal-and-optical-signal conversion chip substrate 601 according to the solder bonding. This enables to be completed the optical communication device 600, as shown in FIG. 17, mounting the semiconductor chip 10, the RF-OPT chip 21, the lenses 28, and the optical fiber 29 on the same substrate.

Thus, according to the embodiments of the optical communication device 600 and the method of manufacturing the same according to the present invention, it is possible to realize the semiconductor-chip-to-optical-module interconnection between the semiconductor chip 10 and the optical module 202 according to a wireless-to-optical connection at only one connection step. This enables the existing antenna-built-in semiconductor chip 10 to be easily connected to the optical fiber 20 through the wireless-signal-and-optical-signal conversion chip substrate 601 just under the semiconductor chip 10.

Accordingly, it is possible to manufacture and present the optical communication device 600 with a high-speed optical interface, which is possible to send or receive at a high speed the signal converted from electric signal to the optical signal and vice versa between the semiconductor chip 10 and the RF-OPT chip 21. If, moreover, the RF-OPT chip 21 is previously arranged in the wireless-signal-and-optical-signal conversion chip substrate 601, then the assembly steps may be carried out in the same apparatus as a past one without any changing the past method. It is to be noted that the detailed description of an operation example of the optical communication device 600 at the connection in the wireless communication will be omitted because it is similar to that of the operation example of the optical communication device 100 shown in FIG. 9 at the connection in the wireless communication.

### [Embodiment 7]

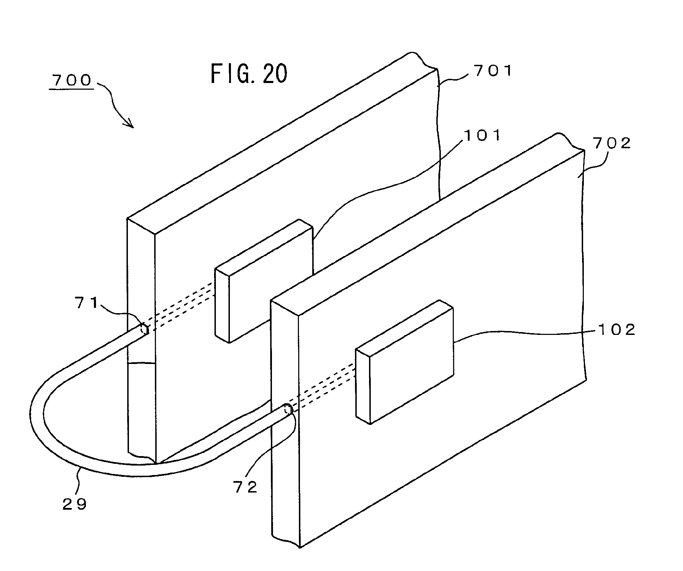

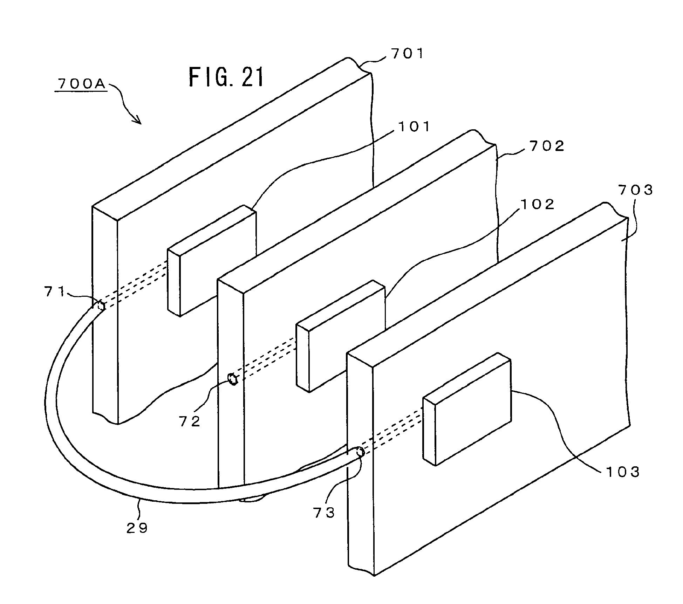

FIGS. 20 and 21 show configurations of optical communication devices 700 and 700A as a seventh embodiment of the invention. In the optical communication device 700, two wireless-signal-and-optical-signal conversion chip substrates 701 and 702 are provided and the optical fiber 29 connects these wireless-signal-and-optical-signal conversion chip substrates 701 and 702.

In the optical communication device 700 shown in FIG. 20, two wireless-signal-and-optical-signal conversion chip substrates 701 and 702 are provided, which is preferably applied to a motherboard of a personal computer. The wireless-signal-and-optical-signal conversion chip substrates 701 and 702 are provided so as to be adjacent to each other and used with respective bodies of the wireless-signal-and-optical-signal conversion chip substrates 701 and 702 standing in parallel. The wireless-signal-and-optical-signal conversion chip substrates 701 and 702 are respectively provided with the semiconductor chips 101, 102 as described in the first through sixth embodiments of the invention, the RF-OPT chips 21, 21a, 21b, the lenses 28, not shown, and the like. The wireless-signal-and-optical-signal conversion chip substrates 701 and 702 are also respectively provided with a connection terminal or taking-out port 71 or 72 for connecting the optical fiber 29 to the wireless-signal-and-optical-signal conversion chip substrate 701, 702 or for taking the optical fiber 29 out thereof.

The optical fiber 29 connects these two wireless-signal-and-optical-signal conversion chip substrates 701 and 702. When an RF signal S11 is transmitted from the wireless-signal-and-optical-signal conversion chip substrate 701 to the wireless-signal-and-optical-signal conversion chip substrate 702. The wireless-signal-and-optical-signal conversion chip substrate 701 converts the RF signal S11 to the collimated light which is transmitted to the wireless-signal-and-optical-signal conversion chip substrate 702 through the optical fiber 29. The wireless-signal-and-optical-signal conversion chip substrate 702 converts the collimated light received from the optical fiber 29 to the electric (RF) signal S11. The converted RF signal S11 is transmitted to the semiconductor chip 102 within wireless communication. This enables the semiconductor chip 102 to receive the RF signal S11 from the semiconductor chip 101.

In this embodiment, optical communication processing is not carried out in the same wireless-signal-and-optical-signal conversion chip substrate 201 or 501 as described in the second or fifth embodiment, but the two wireless-signal-and-optical-signal conversion chip substrates 701 and 702 are connected by the optical fiber 29 and are able to perform optical communication processing to each other. It is to be noted that the wireless-signal-and-optical-signal conversion chip substrates 701 and 702 is not necessary to stand adjacent to each other but may be apart from each other as shown in FIG. 21.

The optical communication device 700A shown in FIG. 21 contains three wireless-signal-and-optical-signal conversion chip substrates 701, 702 and 703, which is preferably applied to an expansion board of a personal computer. The wireless-signal-and-optical-signal conversion chip substrates 701, 702 and 703 are provided so as to lie in a row and used with respective bodies of the wireless-signal-and-optical-signal conversion chip substrates 701, 702 and 703 standing in parallel. The wireless-signal-and-optical-signal conversion chip substrates 701, 702 and 703 are respectively provided with the semiconductor chips 101, 102, 103 as described in the first through sixth embodiments of the invention, the RF-OPT chips 21, 21a, 21b, the lenses 28, not shown, and the like. The wireless-signal-and-optical-signal conversion chip substrates 701, 702 and 703 are also respectively provided with a connection terminal or taking-out port 71 or 72 for connecting the optical fiber 29 to the wireless-signal-and-optical-signal conversion chip substrate 701, 702 or for taking the optical fiber 29 out thereof.

In this case, the optical fiber 29 connects the wireless-signal-and-optical-signal conversion chip substrates 701 and 703. In other words, the wireless-signal-and-optical-signal conversion chip substrate 702 stands between the wireless-signal-and-optical-signal conversion chip substrates 701 and 703. When an RF signal S11 is transmitted from the wireless-signal-and-optical-signal conversion chip substrate 701 to the wireless-signal-and-optical-signal conversion chip substrate 703, the wireless-signal-and-optical-signal conversion chip substrate 701 converts the RF signal S11 to the collimated light which is transmitted to the wireless-signal-and-optical-signal conversion chip substrate 703 through the optical fiber 29. The wireless-signal-and-optical-signal conversion chip substrate 703 converts the collimated light received from the optical fiber 29 to the electric (RF) signal S11. The converted RF signal S11 is transmitted to the semiconductor chip 103 within wireless communication. This enables the semiconductor chip 103 to receive the RF signal S11 from the semiconductor chip 101.

Thus, according to the embodiment of the optical communication device 700 according to the present invention, the two wireless-signal-and-optical-signal conversion chip substrates 701 and 702 are connected to each other through the optical fiber 29 so that the wireless-signal-and-optical-signal conversion chip substrates 701 and 702 can perform the optical communication processing to each other. According to the embodiment of the optical communication device 700A according to the present invention, two wireless-signal-and-optical-signal conversion chip substrates 701 and 703 are selected from the three wireless-signal-and-optical-signal conversion chip substrates 701, 702 and 703 and are connected to each other through the optical fiber 29 so that the wireless-signal-and-optical-signal conversion chip substrates 701 and 703 can perform the optical communication processing to each other.

Accordingly, the RF signal S11 or S12 can be transmitted between the semiconductor chips 101 and 102 or between the semiconductor chips 101 and 103 so that it is possible to enhance freedom in a layout design of the wireless-signal-and-optical-signal conversion chip substrate 701 or the like and the like, thereby being applicable to various designs thereof.

### [Embodiment 8]

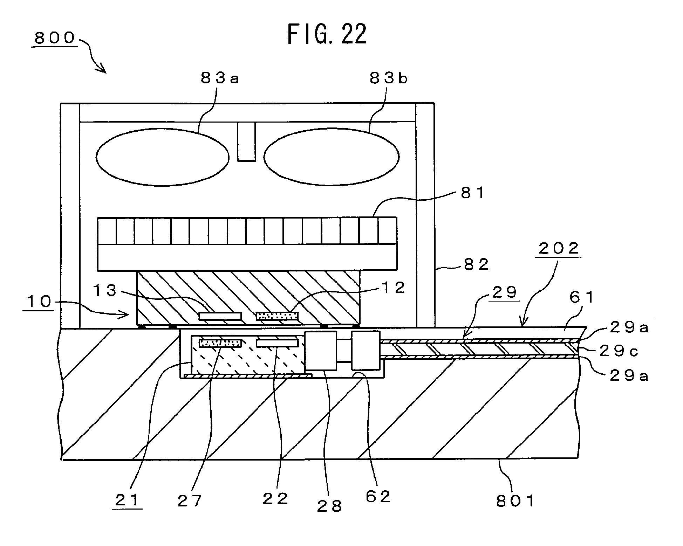

FIG. 22 shows a configuration of an optical communication device 800 as an eighth embodiment of the invention. In this embodiment, the optical communication device 800 has a cooling member. The optical communication device 800 shown in FIG. 22 contains the semiconductor chip 10, a wireless-signal-and-optical-signal conversion chip substrate 801, a heat sink 81, cooling fans 83a, 83b and a frame 82 for the cooling fans. The wireless-signal-and-optical-signal conversion chip substrate 801 has a trench, which is similar to the wireless-signal-and-optical-signal conversion chip substrate described in the sixth embodiment. It goes without saying that the wireless-signal-and-optical-signal conversion chip substrate 801 is not limited to the wireless-signal-and-optical-signal conversion chip substrate having the trench but may be any of the wireless-signal-and-optical-signal conversion chip substrates 20, 201, 301, 401, and 501 described in the first through fifth embodiments of the invention.

In this embodiment, the semiconductor chip 10 mounts the heat sink 81 which radiates heat generated in the semiconductor chip 10. As the heat sink 81, cooling block member made of aluminum having well heat radiation property, which has a fin, is used. The frame 82 for the cooling fans stands so as to surround the heat sink 81 and the semiconductor chip 10. In this embodiment, two cooling fans 83a, 83b are attached into an upper potion of the frame 82. The cooling fan 83a is used for, for example, exhaustion and exhausts the heat radiated from the heat sink 81 toward outside. The cooling fan 83b is used for, for example, ventilation and ventilates air taken from outside toward the heat sink 81 to diffuse the heat radiated from sink 81. A motor, not shown drives these cooling fans 83a and 83b.

Thus, according to the embodiment of the optical communication device 800 according to the present invention, the optical communication device 800 contains the cooling member including the heat sink 81, the cooling fans 83a, 83b and the frame 82 for the cooling fans so that the heat generated in the semiconductor chip 10 can be radiated and/or diffused effectively by utilizing the cooling member. This enables the optical communication device in which the wireless-signal-and-optical-signal conversion chip substrate 801 mounts the semiconductor chip 10 having a good thermal property to be presented.

The above-mentioned embodiments of the optical communication devices according to the invention are very preferably applicable to a high-speed optical interface apparatus that performs transmission and/or reception of a signal at a high speed between a semiconductor chip and a wireless-signal-and-optical-signal conversion chip.

It should be understood by those skilled in the art that various modifications, combinations, sub-combinations and alterations may occur depending on design requirements and other factors insofar as they are within the scope of the appended claims or the equivalents thereof.

## Claims

1. An optical communication device comprising:
a semiconductor chip that performs wireless communication, the semiconductor chip including a first wireless communication circuit element and a first antenna element, the first wireless communication circuit element being connected to the first antenna element; and
a wireless-signal-and-optical-signal conversion chip substrate that mounts the semiconductor chip, the wireless-signal-and-optical-signal conversion chip substrate including a second wireless communication circuit element, a second antenna element and an optical communication element, the second wireless communication circuit element being connected to the second antenna element, the optical communication element being connected to the second wireless communication circuit element,
wherein the wireless-signal-and-optical-signal conversion chip substrate mounts the semiconductor chip with the first antenna element of the semiconductor chip and the second antenna element of the wireless-signal-and-optical-signal conversion chip substrate being faced with each other.

2. The optical communication device according to Claim 1,
wherein the wireless-signal-and-optical-signal conversion chip substrate further includes a substrate body that is provided with the second antenna element faced with the first antenna element of the semiconductor chip, the second wireless communication circuit element connected to the second antenna element, and the optical communication element; and
wherein the optical communication element contains:
an electric-signal-to-optical-signal conversion element that converts an electric signal to an optical signal, the electric-signal-to-optical-signal conversion element being connected to the second wireless communication circuit element;
an optical-signal-to-electric-signal conversion element that converts an optical signal to an electric signal, the optical-signal-to-electric-signal conversion element being connected to the second wireless communication circuit element; and
an optical fiber that is connected to the electric-signal-to-optical-signal conversion element and the optical-signal-to-electric-signal conversion element.

3. The optical communication device according to Claim 2,
wherein the wireless-signal-and-optical-signal conversion chip substrate mounts two semiconductor chips and the two semiconductor chips are connected to each other by means of the optical fiber in the wireless-signal-and-optical-signal conversion chip substrate.

4. The optical communication device according to Claim 2,
wherein the wireless-signal-and-optical-signal conversion chip substrate mounts two semiconductor chips and the two semiconductor chips are connected to each other by means of the optical fiber in the wireless-signal-and-optical-signal conversion chip substrate, the optical fiber being bent to a predetermined shape.

5. The optical communication device according to Claims 2 to 4, wherein the wireless-signal-and-optical-signal conversion chip substrate includes a trench in which a recess portion is provided at a position where the electric signal is receivable and a groove is communicated to the recess portion;
wherein the trench receives the second antenna element, the second wireless communication circuit element, the electric-signal-to-optical-signal conversion element, the optical-signal-to-electric-signal conversion element and the optical fiber with them being arranged in the recess portion and the groove.

6. The optical communication device according to Claims 1 to 5, further comprising a cooling member that cools the semiconductor chip.

7. A method of manufacturing an optical communication device that performs an optical communication by connecting to an optical fiber a semiconductor chip including a first wireless communication circuit element and a first antenna element, the first wireless communication circuit element being connected to the first antenna element, the method comprising the steps of:
preparing a wireless-signal-and-optical-signal conversion chip substrate by setting a second wireless communication circuit element that performs wireless communication on the semiconductor chip, a second antenna element that performs the wireless communication on the semiconductor chip and an optical communication element that performs an optical communication between the second wireless communication circuit element and the optical fiber on a substrate body and by connecting the second wireless communication circuit element, the second antenna element, the optical communication element, and the optical fiber to each other;
aligning the first antenna element of the semiconductor chip and the second antenna element of the wireless-signal-and-optical-signal conversion chip substrate to be faced with each other and mounting the semiconductor chip on the wireless-signal-and-optical-signal conversion chip substrate.

8. The method of manufacturing the optical communication device according to Claim 7, wherein the step of preparing the wireless-signal-and-optical-signal conversion chip substrate includes the sub-steps of:
setting the second antenna element, the second wireless communication circuit element, and the optical communication element on the substrate body, the optical communication element containing an electric-signal-to-optical-signal conversion element that converts an electric signal to an optical signal, an optical-signal-to-electric-signal conversion element that converts an optical signal to an electric signal and the optical fiber; and
connecting the second antenna element to the second wireless communication circuit element, which are arranged on the substrate body, connecting the electric-signal-to-optical-signal conversion element and the optical-signal-to-electric-signal conversion element to the second wireless communication circuit element, and connecting the electric-signal-to-optical-signal conversion element and the optical-signal-to-electric-signal conversion element to the optical fiber.
